# EUROPÄISCHE PATENTSCHRIFT

(11) **EP 2 871 484 B1**
(45) Veröffentlichungstag und Bekanntmachung des Hinweises auf die Patenterteilung: **22.03.2017**
(21) Anmeldenummer: 14191894.6
(22) Anmeldetag: 05.11.2014
(51) Int. Cl.: G01R 15/16, H04B 3/56

(54) **Koppler, Kopplermodul und Kopplersystem zum Anschluss von Mess- und/oder Kommunikationsmitteln an ein Energieversorgungsnetzwerk**
Coupler, coupling module and coupler system for the connection of measuring and/or communication means to a power distribution network
Coupleur, module de coupleur et système de coupleur destinés à raccorder des moyens de communication et/ou de mesure sur un réseau d'alimentation électrique

(30) Priorität: 07.11.2013 DE 102013222655; 03.11.2014 DE 102014222420
(43) Veröffentlichungstag der Anmeldung: 13.05.2015
(73) Patentinhaber: Power Plus Communications AG, 68167 Mannheim (DE)
(72) Erfinder: Veselcic, Marko, 67122 Altrip (DE); Lehmann, Josef, 79761 Waldshut-Tiengen (DE)
(74) Vertreter: Patent- und Rechtsanwälte Ullrich & Naumann

(56) Entgegenhaltungen:
- EP-A1- 1 079 538
- EP-A1- 1 309 098
- EP-A1- 1 770 871
- DE-B- 1 217 450

## Beschreibung

Die Erfindung betrifft einen Koppler zum Anschluss von Mess- und/oder Kommunikationsmitteln an ein Energieversorgungsnetzwerk, insbesondere ein Mittelspannungsnetzwerk. Die Erfindung betrifft ferner ein Kopplermodul, das durch ein Koppelnetzwerk zu einem erfindungsgemäßen Koppler ergänzbar ist, sowie ein Kopplersystem.

Bei Powerline-Communication (PLC) werden hochfrequente PLC-Signale über gewöhnliche Energieversorgungsleitungen übertragen. Die Breitbandvariante von PLC - Breitband-Powerline (BPL) - nutzt üblicherweise Frequenzen zwischen 1 und 30 MHz. Weite Verbreitung findet PLC nicht nur bei Datenübertragungen innerhalb von Gebäuden sondern auch bei Datenübertragungen auf Energieversorgungstrassen, beispielsweise zwischen einer Trafostation und einem Kunden oder einer Mittelspannungsstrecke. Als Übertragungsmedien sind Niederspannungsnetze (mit Wechselspannungen mit Effektivwerten bis 1 kV) ebenso in Verwendung wie Mittelspannungsnetze (mit Wechselspannungen mit Effektivwerten von über 1 kV bis 52 kV). Die PLC-Signale werden mittels Koppler in die Energieversorgungsleitungen ein- bzw. ausgekoppelt, wobei die wichtigsten Vertreter kapazitive Koppler sind. Im Mittelspannungsbereich sind kapazitive Koppler nach IEC 60358 genormt.

Auch für Messaufgaben innerhalb eines Energieversorgungsnetzwerks sind kapazitive Koppler gebräuchlich. Hierbei wird ein Messsignal aus dem Energieversorgungsnetzwerk ausgekoppelt, das für eine zu messende Größe innerhalb des Energieversorgungsnetzwerks repräsentativ ist. Das Messsignal weist dabei eine deutlich niedrigere Spannung als die zu messende Größe auf.

Es sind auch kapazitive Koppler bekannt, die sowohl für Mess- als auch für Kommunikationszwecke genutzt werden können. Ein derartiger Koppler ist beispielsweise in der deutschen Patentanmeldung 10 2014 221 108 der Anmelderin beschrieben.

Darüber hinaus zeigen EP 1 309 098 A1 und EP 1 770 871 A1 Koppeleinrichtungen.

Kapazitive Mittelspannungskoppler nach IEC 60358 werden derzeit beispielsweise von den Firmen Power Communications Plus AG oder Arteche Lantegi Elkartea SA hergestellt und vertrieben. Diese Koppler umfassen eine Koppelkapazität, ein Koppelnetzwerk und ein Gehäuse mit geeigneten Anschlussmitteln. Die Koppelkapazität lässt höherfrequente Signalanteile aus dem Mittelspannungsnetzwerk zu dem Koppelnetzwerk durch, während die Versorgungsspannung abgekoppelt oder zumindest erheblich reduziert wird. Das Koppelnetzwerk sorgt meist für eine galvanische Trennung zu dem Mittelspannungsnetzwerk sowie einer weiteren Filterung und gegebenenfalls Aufbereitung der Signale. Zudem dient es dem Anschluss von Mess- und/ oder Kommunikations-Equipment. Die Anschlussmittel stellen eine leitende Verbindung zwischen dem Mittelspannungsnetzwerk und der Koppelkapazität her. In Freileitungsanlagen sind die Anschlussmittel meist durch blanke Leiter gebildet, die mit den Leiterseilen verbunden sind. Die Anschlussmittel können aber auch - insbesondere bei Erdkabelanlagen - durch Kabeltrosse gebildet sein, die üblicherweise mit Sammelschienen des Mittelspannungsnetzwerks verbunden werden. Kabeltrosse sind im praktischen Einsatz 3 m lang und länger.

Nachteilig an den bekannten Mittelspannungskopplern ist, dass diese teuer in der Herstellung sind, da sie meist zu einem nicht unerheblichen Anteil in Handarbeit hergestellt werden. Ferner ist zur Vermeidung von Überspannungsschäden eine Feldsteuerung zwischen den einzelnen Komponenten (Kabeltrosse, Gehäuse des Kopplers, Kabelendverschluss, etc.) notwendig, wodurch der Entwurf der Koppler aufwändig ist. Darüber hinaus sind die für Kabeltrosse notwendigen Kabel teuer, was die Gesamtkosten der Koppler weiter erhöht. Zudem wirken sich Kabeltrosse negativ auf die Signalqualität aus und sind mechanisch problematisch, beispielsweise hinsichtlich der thermischen Ausdehnung.

Weiter problematisch ist, dass die bekannten Koppler - insbesondere für den Mittelspannungsbereich - eine relativ große Bauform aufweisen. Dies hat unter anderem zur Folge, dass für einige kompakte Lastschaltanlagen, wie beispielsweise die Minex C der Firma Fritz Driescher KG, keine BPL (Breitband Powerline)-Koppler auf dem Markt verfügbar sind, die in diese Anlagen problemlos integriert werden können. Dieses Problem wird dadurch gelöst, dass die Koppler außerhalb der Schaltanlage angebracht werden, was wegen der beengten räumlichen Gegebenheiten zu einem weiter erhöhten Installationsaufwand führt. Ähnliche Verhältnisse können auch in Niederspannungsnetzen auftreten.

Der vorliegenden Erfindung liegt daher die Aufgabe zugrunde, einen Koppler, ein Kopplermodul und ein Kopplersystem der eingangs genannten Art anzugeben, der/ das möglichst kompakt aufgebaut, kostengünstig herstellbar und auch in beengten Umgebungen installierbar ist.

Erfindungsgemäß wird die voranstehende Aufgabe durch die Merkmale der Ansprüche 1, 12 und 14 gelöst.

In erfindungsgemäßer Weise ist zunächst erkannt worden, dass ein kostengünstiger Koppler dann ermöglicht ist, wenn der Koppler zum direkten Befestigen an ein netzspannungsführendes Betriebsmittel des Energieversorgungsnetzwerks ausgebildet ist. Dies wird dadurch erreicht, dass der netzseitige Anschluss des Kopplers nicht nur zum Anschließen an das Energieversorgungsnetzwerk - also zum elektrischen Kontaktieren - ausgebildet ist, sondern auch dazu geeignet ist, den an dem netzspannungsführenden Betriebsmittels befestigten Koppler zu tragen. Dadurch kann auf die sonst notwendigen, zusätzlichen Haltevorrichtungen verzichtet werden. Zudem sind keine kostspieligen Anschlussmittel, wie Kabeltrosse, notwendig. Beide Maßnahmen reduzieren sowohl die Herstell- als auch die Installationskosten.

Zum Realisieren dieser Grundidee weist der erfindungsgemäße Koppler ein Gehäuse, eine erste und eine zweite Elektrode, ein Dielektrikum und ein Koppelnetzwerk auf, wobei das Dielektrikum zwischen den beiden Elektroden angeordnet ist. Die erste Elektrode, die zweite Elektrode und das Dielektrikum bilden eine Koppelkapazität und sind innerhalb des Gehäuses angeordnet. Die erste Elektrode ist zum Verbinden mit dem Energieversorgungsnetzwerk ausgestaltet, die zweite Elektrode dient dem Verbinden mit dem Koppelnetzwerk. Das Koppelnetzwerk ist damit netzseitig mit der zweiten Elektrode des Kopplers verbunden. Niederspannungsseitig weist das Koppelnetzwerk Anschlussmittel auf, an die Mess- und/oder Kommunikationsmittel angeschlossen werden können.

An der ersten und an der zweiten Elektrode ist jeweils an der dem Dielektrikum abgewandten Seite der jeweiligen Elektrode ein Befestigungsmittel ausgebildet. Über dieses jeweilige Befestigungsmittel wird ein Anschluss zu dem Energieversorgungsnetzwerk bzw. dem Koppelnetzwerk ermöglicht. Zudem ist das Befestigungsmittel an der ersten Elektrode zum Befestigen des Kopplers an einem netzspannungsführenden Betriebsmittel des Energieversorgungsnetzwerks ausgebildet. Dies wird dadurch erreicht, dass das Befestigungsmittel an der ersten Elektrode und die erste Elektrode selbst die Kräfte aufnehmen kann, die beim Befestigen des Kopplers an dem Betriebsmittel und/oder beim Halten des Kopplers an dem Betriebsmittel üblicherweise entstehen. Dies kann zum einen durch eine entsprechend mechanisch stabile Ausgestaltung der Elektrode und des Befestigungsmittels geschehen, andererseits können zusätzlich Kräfte an Teile des Gehäuses abgeleitet werden. Es können auch weitere Maßnahmen vorgesehen sein, wie beispielsweise Halteflächen für eine Zange oder ein Maulschlüssel, wodurch Installationskräfte noch besser aufgenommen werden können.

Durch den kompakten Aufbau ist es möglich, einen relativ leichten Koppler zu erzielen. Die erfindungsgemäßen Koppler können mit einem Gewicht deutlich unter 1 kg hergestellt werden. Erste Modelle des erfindungsgemäßen Kopplers haben sogar gezeigt, dass der gesamte Koppler mit einem Gewicht unter 500 g herstellbar ist. Dadurch ist die mechanische Belastung auf die einzelnen Teile des Kopplers, insbesondere auf das Befestigungsmittel an der ersten Elektrode, überschaubar. Dadurch kann der Koppler für die verschiedensten Einsatzszenarien problemlos eingesetzt werden. Gleichzeitig ist durch die geringe Anzahl von Bauteilen ein maschinelles Zusammensetzen des Kopplers möglich, was wiederum die Produktionskosten positiv beeinflusst. Damit kann ein kompakter, kostengünstig herstellbarer und auch in beengten Umgebungen installierbarer Koppler erzielt werden. Durch die Minimierung der beteiligten Komponenten auf das Wesentliche sowie die mechanische Konstruktion kann eine Miniaturisierung in Volumen, Längsausdehnung entlang der Anschlussachse sowie Gewicht erreicht werden. Damit kann eine Installation direkt in einem Traforaum oder im Kabelanschlussraum einer Lastschaltanlage realisiert werden.

Im Bereich der Energieversorgungsnetzwerke hat sich die Verwendung von Schrauben oder Gewindebolzen zum Verbinden einzelner Betriebsmittel des Energieversorgungsnetzwerks etabliert. Insbesondere im Mittelspannungsbereich bis 24 kV wird dies durch M12-Bolzen bzw. -Schrauben realisiert, die meist einen hexagonalen Kopf aufweisen. Daher ist vorzugsweise das Befestigungsmittel an der ersten und/oder der zweiten Elektrode durch eine Gewindebuchse gebildet, wobei die Abmessung der Gewindebuchse nicht auf M12 beschränkt ist. Dies bedeutet, dass an der dem Dielektrikum abgewandten Seite der jeweiligen Elektrode eine Gewindebuchse vorhanden ist, in die eine Schraube oder ein Gewindebolzen einschraubbar ist. Hierzu bietet es sich an, wenn die Elektrode im Bereich des Befestigungsmittels entsprechend verdickt ist. Technische Realisierungen einer derartigen Gewindebuchse sind aus der Praxis hinlänglich bekannt. Dabei kann beispielsweise die Gewindebuchse an der zweiten Elektrode zur Aufnahme einer M6-Schraube ausgestaltet sein, während die Gewindebuchse an der ersten Elektrode zur Aufnahme einer M12-Schraube ausgebildet ist. Auf diese Weise kann der erfindungsgemäße Koppler direkt an einen M12-Gewindebolzen an einem Betriebsmittel des Energieversorgungsnetzwerks angeschraubt werden, während das Koppelnetzwerk über eine M6-Schraube mit der zweiten Elektrode verschraubt wird.

Zum Erzielen einer besonders universell einsetzbaren Koppelkapazität sind die erste Elektrode und die zweite Elektrode vorzugsweise symmetrisch zueinander aufgebaut. Entsprechend wäre das Befestigungsmittel an der ersten Elektrode weitgehend identisch zu dem Befestigungsmittel an der zweiten Elektrode. Wenn also bei einer Ausgestaltung das Befestigungsmittel an der zweiten Elektrode durch eine M6-Gewindebuchse realisiert ist, wäre das Befestigungsmittel an der ersten Elektrode ebenso eine M6-Gewindebuchse.

Vorzugsweise ist das Dielektrikum der Koppelkapazität durch eine Keramik gebildet ist. Beispielhaft sei hierzu auf Strontiumtitanat verwiesen, das bei Keramikkondensatoren weite Verbreitung findet. Durch Verwendung einer Keramik als Dielektrikum kann eine Koppelkapazität erreicht werden, die eine hohe Kapazität bei geringer Baugröße und gleichzeitig geringem Gewicht aufweist. Dies wirkt sich wiederum günstig auf das Gesamtgewicht des Kopplers aus. Bei einer symmetrischen Ausgestaltung der ersten und der zweiten Elektrode sind die beiden Elektroden nicht nur symmetrisch zueinander, sondern auch symmetrisch zu der Keramik.

Für eine besonders universelle Einsetzbarkeit des Kopplers, insbesondere bei einer symmetrischen Ausgestaltung der Elektroden, kann ein Adapter vorgesehen sein, mit dem das Befestigungsmittel an der ersten Elektrode an verschiedene Installationsszenarien angepasst werden kann. Dabei ist der Adapter vorzugsweise lösbar an dem Befestigungsmittel der ersten Elektrode angebracht. Bei Verwendung eines Adapters wäre die erste Elektrode mittels des Adapters mit dem Betriebsmittel verbunden. Auch dies ist eine "Befestigung des Kopplers an einem netzspannungsführenden Betriebsmittel" im Sinne der Erfindung. Wenn beispielsweise das Befestigungsmittel an der ersten und der zweiten Elektrode durch eine M6-Gewindebuchse realisiert ist, könnte der Adapter einen M6-Gewindebolzen und an der dem Gewindebolzen abgewandten Seite eine M12-Gewindebuchse aufweisen. Der Adapter würde dann mit dem M6-Gewindebolzen in die M6-Gewindebuchse an der ersten Elektrode eingeschraubt werden und die M12-Gewindebuchse an dem Adapter würde zur Befestigung an einem M12-Gewindebolzen eines Energieversorgungsnetzwerks verwendet.

Bei Verwendung eines Adapters zur Befestigung der ersten Elektrode an einem Betriebsmittels des Energieversorgungsnetzwerks kann der Adapter dazu beitragen, die Kräfte, die durch das Befestigen des Kopplers an dem Betriebsmittel und/oder während des Haltens des Kopplers durch das Betriebsmittel entstehen, aufzunehmen. Hierzu können Adapter und Gehäuse derart zusammenwirken, dass die auf den Adapter wirkenden Kräfte zumindest teilweise an das Gehäuse abgeleitet werden. Dies kann dadurch erreicht werden, dass der Adapter durch eine entsprechend ausgestaltete Öffnung am Gehäuse des Kopplers geführt wird, die den Adapter geeignet abstützen. Außerdem kann der Adapter einen nicht-kreisrunden Querschnitt aufweisen und beispielsweise sechseckig ausgebildet sein. Dadurch können die bei Installation des Kopplers entstehenden Kräfte besser an das Gehäuse abgeleitet werden. Zur Aufnahme von Kräften bei der Installation kann an dem Adapter zudem ein Haltebereich ausgebildet sein, an dem mit einem geeigneten Werkzeug die Kraft zum Befestigen aufgebracht werden kann. So könnte der Haltebereich als Außensechskant ausgebildet sein, so dass ein Maulschlüssel angesetzt werden kann. Wenn der Adapter beispielsweise eine M12-Gewindebuchse aufweist, so kann der Maulschlüssel zum Festziehen einer M12-Schraube oder eines M12-Gewindebolzens genutzt werden.

Zur weiteren mechanischen Stabilisierung und zur Verbesserung der elektrischen Eigenschaften könnte die Koppelkapazität mit dem Kopplergehäuse vergossen sein. Dies bietet sich insbesondere dann an, wenn erste Elektrode, Dielektrikum und zweite Elektrode bereits als eine Koppelkapazität vorproduziert sind und als ein Block gemeinsam in das Gehäuse des Kopplers eingesetzt werden. Produktionsprozesse zur Herstellung entsprechender Koppelkapazitäten sind aus der Praxis bekannt. Es sind sogar Koppelkapazitäten am Markt verfügbar, die sich prinzipiell in dem erfindungsgemäßen Koppler verwenden lassen. Prinzipiell sind diese Koppelkapazitäten durch die fehlende Isolationskoordination zwar nicht direkt an dem Energieversorgungsnetz einsetzbar. Mit dem Einbau in das Gehäuse kann die fehlende Isolationskoordination jedoch erzielt werden. Durch eine Vorproduktion der Koppelkapazität ergibt sich eine besondere mechanische Stabilität sowie genau definierte elektrische Eigenschaften der Koppelkapazität. Beim Verbinden der Koppelkapazität mit dem Gehäuse könnte der Raum zwischen Gehäuse und Koppelkapazität mit einem Vergussmaterial aufgefüllt werden. Dabei ist es beim Vergießen von Vorteil, dass möglichst wenige, am besten keine Lufteinschlüsse im Bereich der Elektrode verbleiben, da diese zu Teilentladungen führen können.

Vorzugsweise ist das Gehäuse des Kopplers dabei aus Silikon oder Silikonpolymer hergestellt. Dadurch entsteht ein leicht herstellbares, mechanisch stabiles, strapazierfähiges und dennoch gut bearbeitbares Gehäuse. Ferner verfügen diese Werkstoffe über eine ausreichende Hochspannungsverträglichkeit. Als Vergussmaterial bietet sich dann ebenso Silikon an, das sich dann besonders gut mit dem Gehäuse verbinden kann.

Vorzugsweise ist an dem Gehäuse oder in dem Gehäuse bei der zweiten Elektrode an der dem Dielektrikum abgewandten Seite ein Anschlussraum ausgebildet. In dem Anschlussraum kann das Koppelnetzwerk oder ein Teil des Koppelnetzwerks angeordnet sein. Denkbar wäre beispielsweise, dass lediglich ein Übertrager in dem Anschlussraum angeordnet ist, während ein Hochpass-Filter oder andere Elemente des Koppelnetzwerks außerhalb des Anschlussraums angeordnet und über ein Anschlusskabel verbunden sind. Der Anschlussraum kann als Ausnehmung in dem Gehäuse ausgebildet sein. Zum Schutz des Koppelnetzwerks bzw. des Teils des Koppelnetzwerks im Anschlussraum kann der Anschlussraum mit einem Vergussmittel vergossen sein.

Zum Verschließen des Anschlussraums kann eine Abdeckung vorgesehen sein. Anschlussraum und Abdeckung wirken dabei vorzugsweise so zusammen, dass ein weitgehend abgeschlossener Bereich für das Koppelnetzwerk oder ein Teil des Koppelnetzwerks entsteht. An dem Gehäuse kann eine Anti-Rutsch-Lippe ausgebildet sein, die zusammen mit einer entsprechend ausgestalteten Abdeckung ein Abrutschen der Abdeckung verhindert. Zum Herausführen eines Anschlusskabels für Mess- und/oder Kommunikationsmittel kann an der Abdeckung eine Kabeltülle vorgesehen sein, durch die ein Anschlusskabel führbar ist.

Zur Erhöhung des Kriechweges für Kriechentladungen und damit zur Vermeidung eines elektrischen Überschlags können an einer Außenseite des Gehäuses eine oder mehrere Isolierrippen angeordnet sein. Die Isolierrippe/n sind dabei vorzugsweise umlaufend um das Gehäuse ausgebildet. Zum Erzielen einer möglichst effektiven Erhöhung der Kriechstrecken ist dabei die Isolierrippe vorzugsweise in einer Ebene parallel zu der ersten und der zweiten Elektrode angeordnet. Da sich Kriechentladungen stets zwischen den beiden Elektroden ausbilden, kann auf diese Weise effektiv die Kriechstrecke erhöht werden. Durch unterschiedlich breit ausgeprägte Isolierrippen kann der Koppler sowohl für einen Außen- als auch einen Inneneinsatz angepasst werden. Es ist möglich, dass eine Isolierrippe direkt an der Außenwandung des Gehäuses angeformt ist. Es wäre aber auch denkbar, dass die Isolierrippen separat beispielsweise aus Silikon hergestellt werden und danach auf das Gehäuse geschoben werden. Hier sollte dann eine kraftschlüssige Verbindung zwischen Isolierrippe und Gehäuse bestehen. Eventuell könnten derartige Isolierrippen auch formschlüssig mit dem Gehäuse verbunden sein und durch ein Klebemittel, beispielsweise wiederum Silikon, an dem Gehäuse verklebt werden.

Prinzipiell kann das Gehäuse in verschiedensten Geometrien ausgebildet sein. So ist beispielsweise denkbar, das Gehäuse quader- oder würfelförmig auszugestalten. Vorzugsweise ist das Gehäuse an die jeweilige Installationssituation angepasst. Verschiedensten Installationsszenarien kann dann besonders gut Rechnung getragen werden, wenn das Gehäuse selbst - entsprechend einer besonders bevorzugten Ausgestaltung - weitgehend zylindrisch oder auch fassförmig aufgebaut ist. Dabei sind die erste und die zweite Elektrode vorzugsweise parallel zu der Deckfläche des Zylinders angeordnet. Auf diese Weise kann ein Gehäuse erreicht werden, das mit relativ geringem Platzbedarf an das spannungsführende Betriebsmittel befestigt werden kann. Dies trifft insbesondere dann zu, wenn das Befestigungsmittel an der ersten Elektrode bzw. dem dort befestigten Adapter durch eine Gewindebuchse realisiert ist. Durch zylindrische Ausgestaltung des Gehäuses kann das Einschrauben der Gewindebuchse in einen feststehenden Gewindebolzen ohne zusätzlichen Platzbedarf erfolgen.

Zur weiteren Vereinfachung der Installation können das Befestigungsmittel an der ersten Elektrode und gegebenenfalls das Befestigungsmittel an der zweiten Elektrode bei der Zylinderachse des zylindrischen Gehäuses angeordnet sein. Bei entsprechender Anordnung der Befestigungsmittel bei der Zylinderachse können das Gehäuse und die erste und die zweite Elektrode im Wesentlichen rotationssymmetrisch zu der Zylinderachse aufgebaut sein.

Das Gehäuse ist flach ausgestaltet. Unter "flach" wird in diesem Zusammenhang verstanden, dass das Gehäuse in einer Richtung senkrecht zu einer Verbindungslinie zwischen den Befestigungsmitteln an der ersten und der zweiten Elektrode eine größere Abmessung aufweist als in einer Richtung parallel zu der Verbindungslinie zwischen den Befestigungsmitteln an der ersten und der zweiten Elektrode. Vorzugsweise ist das Verhältnis zwischen der Abmessung in Richtung senkrecht zu der Verbindungslinie im Vergleich zu der Abmessung des Gehäuses in eine Richtung parallel zu der Verbindungslinie größer als 1,5 : 1. Ganz besonders bevorzugter Weise ist das Verhältnis größer als 2 : 1. Auf diese Weise kann zum einen die mechanische Stabilität verbessert werden, zum anderen wird damit ein Beitrag geleistet, eine Installierbarkeit in beengten räumlichen Verhältnissen zu verbessern oder sogar erst zu ermöglichen. Wenn das Gehäuse beispielsweise zylindrisch aufgebaut und die Befestigungsmittel bei der Zylinderachse angeordnet ist, so wäre das Gehäuse "flach", wenn das Verhältnis zwischen dem Durchmesser des Zylinders (Richtung senkrecht zu der Verbindungslinie) und der Höhe des Zylinders (Richtung parallel zu der Verbindungslinie) größer als 1,5 oder besonders bevorzugter Weise größer als 2 ist. Bei der Bestimmung des "Durchmesser des Zylinders" können eventuell vorhandene Isolierrippen mit berücksichtigt sein. Vorzugsweise ist an einer Seite des Gehäuses eine umleitende Abschrägung ausgebildet, wobei die Abschrägung vorzugsweise rotationssymmetrisch zu einer Achse ausgebildet ist, die durch die Befestigungsmittel an der ersten und der zweiten Elektrode definiert ist - nachfolgend auch als Anschlussachse bezeichnet. Eine derartige Abschrägung kann bei der Abstimmung auf die Installationssituation vorteilhaft sein, die mechanische Stabilität durch besseres Abstützen des Befestigungsmittels oder eines Adapters durch das Gehäuse verbessern und gleichzeitig einen Beitrag bei der Stapelbarkeit der Koppler leisten, was nachfolgend noch näher erörtert wird. Bei einem zylindrischen Gehäuse wäre eine Abschrägung beispielsweise durch eine von der Zylinderachse nach außen hin geneigte und dennoch zur Zylinderachse rotationssymmetrische Zylinderdecke erreichbar.

Zur einfacheren Befestigung des Koppelnetzwerks am dem Befestigungsmittel an der zweiten Elektrode kann dieses auf einer Platine aufgebaut sein. Die Platine kann - sofern vorhanden - in dem Anschlussraum des Kopplers angeordnet sein. Dabei kann die Platine einen Anschlussbereich aufweisen, der zur Befestigung der Platine an dem Befestigungsmittel an der zweiten Elektrode ausgestaltet ist. Bei Ausbilden des Befestigungsmittels an der zweiten Elektrode durch eine Gewindebuchse wäre dieser Anschlussbereich durch eine Vorrichtung zum Kontaktieren mit einer Schraube realisiert. Dies kann beispielsweise durch einen Sprengring realisiert sein, der bei Einschrauben und Festziehen einer Schraube in der Gewindebuchse einen Kontakt zu einer Leiterbahn auf der Platine herstellt. Mit diesem Anschlussbereich sind die verschiedenen Elemente des Koppelnetzwerks oder zumindest Teile davon - eventuell auch hintereinander geschaltet - verbunden. Entsprechende Ausgestaltungen von Koppelnetzwerken sind aus der Praxis bekannt.

Zum Schutz von angeschlossenen Mess- und/oder Kommunikationsmitteln kann die Verbindung zwischen Koppelnetzwerk und Mess- und/oder Kommunikationsmittel durch ein besonders ausgestaltetes Kabel realisiert sein. Das Kabel kann derart dimensioniert sein, dass es Mess- und/oder Kommunikationszwecke problemlos erfüllen kann, im Falle eines Durchschlags der Koppelkapazität jedoch zerstört wird. Für Mess- und Kommunikationsaufgaben muss das Kabel lediglich relativ geringen Spannungen und Strömen standhalten. Im Falle eines Durchschlags der Koppelkapazität liegt jedoch eine deutlich höhere Spannung an dem Kabel an. Wenn das Kabel schnell genug auf derartige hohe Spannungen anspricht und zerstört wird, gelangen nur geringe Überspannungen zu dem Mess- und/oder Kommunikationsmittel. Auf diese Weise wird die Verbindung zwischen Energieversorgungsnetzwerk und Mess- und/oder Kommunikationsmittel rasch nach dem Durchschlag unterbunden und damit eine potentiell beschädigende Auswirkung auf das Mess- und/oder Kommunikationsmittel verhindert. Des Weiteren kann ein entsprechender Fehler bei einem Koppler sehr rasch anhand der üblicherweise gut erkennbaren Zerstörung des Kabels detektiert werden, so dass sich die Fehlersuche beschleunigt. Wie das Kabel geeignet dimensioniert werden kann, hängt von verschiedenen Faktoren ab, beispielsweise den angeschlossenen Mess- und/oder Kommunikationsmitteln, deren Spannungs- und Stromfestigkeit oder dem Material des Kabels. Einem Fachmann sind bei entsprechend definierten Randbedingungen Maßnahmen zur Dimensionierung des Kabels bekannt.

In einzelnen Installationsszenarien kann es eine nützliche Weiterbildung sein, wenn der Koppler über einen Befestigungswinkel oder einen Befestigungsarm mit dem Betriebsmittel, beispielsweise einer Sammelschiene des Energieversorgungsnetzwerks, verbunden ist. Der Befestigungswinkel oder Befestigungsarm würde dann an der einen Seite an dem Betriebsmittel befestigt und am dem anderen Ende des Befestigungswinkels oder des Befestigungsarms an dem Befestigungsmittel an der ersten Elektrode (ggf. unter Zwischenschaltung des Adapters). Auf diese Weise kann die Installation des Kopplers noch flexibler erfolgen. Der Befestigungsarm bzw. der Befestigungswinkel sollte dabei kurz ausgeführt sein. Vorzugsweise ist die Länge kleiner als 30 cm, besonders bevorzugter Weise kleiner als 15 cm. Bei dem Befestigungswinkel ist die Länge die Summe der Längen der beiden Schenkel.

Der erfindungsgemäße Koppler ist dabei aus einem erfindungsgemäßen Kopplermodul und einem mit dem Befestigungsmittel an der zweiten Elektrode verbundenen Koppelnetzwerk gebildet. Dabei ist ein Kopplermodul vorzugsweise derart ausgebildet, dass mehrere gleichartige Kopplermodule miteinander verbindbar sind, also eine Art Stapel aus Kopplermodulen gebildet werden kann. In diesem Fall würde das Befestigungsmittel an der ersten Elektrode eines der beiden Kopplermodule mit dem Befestigungsmittel an der zweiten Elektrode des zweiten Kopplermoduls verbunden. Hierzu kann gegebenenfalls ein Adapterstück verwendet werden.

Zur Verbesserung der "Stapelbarkeit" ist das Gehäuse bei der ersten Elektrode vorzugsweise derart auf das Gehäuse bei der zweiten Elektrode abgestimmt, dass ein Kopplermodul in ein zweites gleichartiges Kopplermodul zumindest teilweise formschlüssig eingreift. Dies kann beispielsweise nach dem Nut-Feder-Prinzip erfolgen. Wenn beispielsweise das Kopplermodul ein zylinderförmiges Gehäuse aufweist, so kann an einem Ende des Zylinders im Randbereich bei dem Zylindermantel ein umlaufender Ring vorgesehen sein, der einer Ausnehmung oder eine Stufe an dem anderen Ende des Gehäuses entspricht. Der Ring kann beispielsweise bei der zweiten Elektrode, die Ausnehmung bei der ersten Elektrode angeordnet sein. Beim Zusammenfügen zweier derartiger Kopplermodule würde der Ring des einen Kopplermoduls in die Ausnehmung des anderen Kopplermoduls formschlüssig eingreifen.

Durch Stapeln mehrere Kopplermodule entsteht ein erfindungsgemäßes Kopplersystem, bei dem die Spannungsfestigkeit modular erhöht werden kann. Wenn beispielsweise ein einzelnes Kopplermodul eine Spannungsfestigkeit von 12 kV aufweist, kann durch Stapeln von zwei Kopplermodulen ein Kopplersystem mit einer Spannungsfestigkeit von 24kV realisiert werden. Benötigt werden hierzu lediglich zwei erfindungsgemäße Kopplermodule sowie ein Koppelnetzwerk. Für eine Spannungsfestigkeit von 36 kV können drei Kopplermodule kaskadiert werden, usw. Entsprechend lassen sich mit dem beispielhaft genannten Kopplermodul Kopplersysteme erzielen, die ein Vielfaches von 12 kV an Spannungsfestigkeit aufweisen.

Ein erfindungsgemäßes Kopplersystem besteht damit aus mindestens zwei Kopplermodulen und einem Koppelnetzwerk, wobei die Kopplermodule im Wesentlichen gleich aufgebaut sind. Das Koppelnetzwerk ist mit dessen Anschluss für die Netzseite mit der zweiten Elektrode eines der Kopplermodule verbunden. Niederspannungsseitig sind Mess- und/oder Kommunikationsmittel angeschlossen. Das Kopplermodul mit Koppelnetzwerk wird mit seiner ersten Elektrode mit der zweiten Elektrode eines der weiteren Kopplermodule verbunden. Die erste Elektrode dieses Kopplermoduls wird wiederum - sofern vorhanden - mit der zweiten Elektrode eines der weiteren Kopplermodule verbunden, usw. Auf diese Weise entsteht ein Stapel von Kopplermodulen, der an der einen Seite ein Koppelnetzwerk aufweist und der mit der dem Koppelnetzwerk am weitesten entfernten ersten Elektrode mit dem Energieversorgungsnetzwerk verbunden ist. Entsprechend wäre das Befestigungsmittel an der ersten Elektrode des Kopplermoduls, das innerhalb des Stapels am weitesten von dem Kopplernetzwerk entfernt ist, mit einem spannungsführenden Betriebsmittel des Energieversorgungsnetzwerks verbindbar. Auf diese Weise kann der Koppler gemäß dem ersten Aspekt der Erfindung problemlos durch Stapeln mit mehreren Kopplermodulen zu einem Kopplersystem prinzipiell beliebiger Spannungsfestigkeit ergänzt werden.

Zum Verhindern von Teilentladungen bzw. zur mechanischen Stabilisierung kann der zwischen zwei benachbarten Kopplermodulen gebildete Raum mit einer Vergussmasse ausgefüllt sein. Zum Vergießen kann beispielsweise eines der Kopplermodule mit dem Befestigungsmittel an der zweiten Elektrode nach oben gehalten werden, der in dem Gehäuse gebildete Anschlussraum mit der Vergussmasse ausgefüllt und anschließend ein weiteres Kopplermodul in das Befestigungsmittel an der zweiten Elektrode eingeschraubt werden. Ist zudem bei der ersten Elektrode eine Abschrägung des Gehäuses vorhanden, werden eventuelle Luftanschlüsse nach außen von dem "heißen Leiter" weggedrückt, d.h. von dem spannungsführenden Befestigungsmittel.

Es gibt nun verschiedene Möglichkeiten, die Lehre der vorliegenden Erfindung in vorteilhafter Weise auszugestalten und weiterzubilden. Dazu ist einerseits auf die den Ansprüchen 1, 12 und 14 jeweils nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine Schrägansicht eines ersten Ausführungsbeispiels eines erfindungsgemäßen Kopplers in einer Installationssituation an einer Sammelschiene,
- Fig. 2: eine andere Schrägansicht des erfindungsgemäßen Kopplers nach Fig. 1,
- Fig. 3: eine Seitenansicht des erfindungsgemäßen Kopplers nach Fig. 1,
- Fig. 4: eine Frontansicht des erfindungsgemäßen Kopplers nach Fig. 1,
- Fig. 5: eine Rückansicht des erfindungsgemäßen Kopplers nach Fig. 1,
- Fig. 6: ein Schnitt durch die Anordnung nach Fig. 4 entlang der Linie C - C,
- Fig. 7: eine Vergrößerung eines Schnittes durch einen erfindungsgemäßen Koppler,
- Fig. 8: eine Schrägansicht eines zweiten Ausführungsbeispiels eines erfindungsgemäßen Kopplers in einer Installationssituation an einer Sammelschiene, wobei der Koppler über ein Winkel installiert ist,
- Fig. 9: eine Schrägansicht eines dritten Ausführungsbeispiels eines erfindungsgemäßen Kopplers in einer Installationssituation an einer Sammelschiene, wobei der Koppler über einen Befestigungsarm installiert ist,
- Fig. 10: eine Seitenansicht eines Stapels aus zwei erfindungsgemäßen Kopplermodulen,
- Fig. 11: einen Schnitt durch den Stapel nach Fig. 9 entlang der Linie E - E,
- Fig. 12: eine Seitenansicht des erfindungsgemäßen Kopplers nach Fig. 1 in einer Installationssituation in einem Kabelanschlussraum einer Kompaktschaltanlage, wobei zusätzlich ein Isolierkörper angebracht ist,
- Fig. 13: eine andere Ansicht des Installationssituation nach Fig. 11,
- Fig. 14: ein Schnitt durch die Anordnung nach Fig. 12 entlang der Linie D - D,
- Fig. 15: eine Seitenansicht des Isolierkörpers, der in Fig. 11 angebracht ist,
- Fig. 16: eine andere Ansicht der Isolierkörpers nach Fig. 14 und
- Fig. 17: einen Schnitt durch den Isolierkörper nach Fig. 15 entlang der Linie G - G.

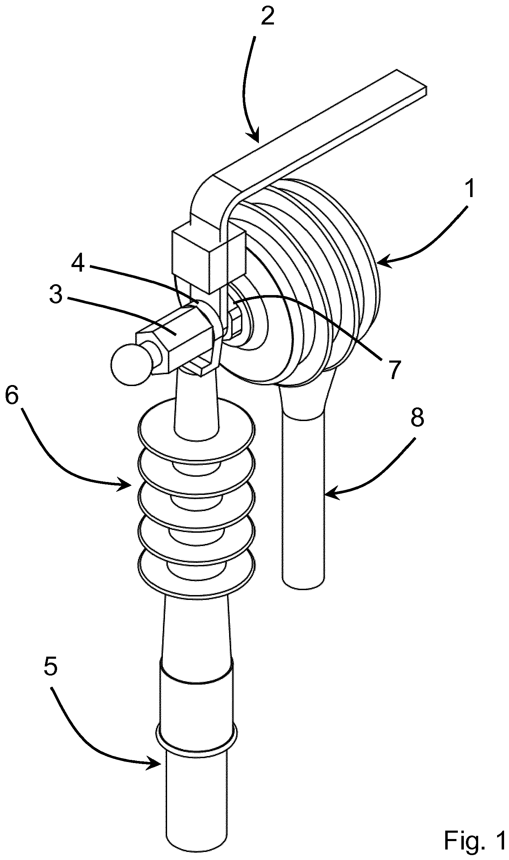

Fig. 1 bis 6 zeigen verschiedene Ansichten eines erfindungsgemäßen Kopplers 1 in einer Installationssituation an einer Sammelschiene 2. Die Sammelschiene 2 ist Teil eines Energieversorgungsnetzwerks, im vorliegenden Fall eines Mittelspannungsnetzwerks. Die Sammelschiene 2 setzt sich in Fig. 1 nach rechts weiter fort und ist nicht - wie in Fig. 1 möglicherweise zu entnehmen - zu Ende. Am Ende der Sammelschiene 2 ist eine Öse ausgebildet, durch die ein M12-Gewindebolzen 3 geführt ist. Mit dem Gewindebolzen 3 ist ein Kabelschuh 4 an der Sammelschiene 2 angebracht. An dem Kabelschuh 4 ist ein Mittelspannungskabel 5 befestigt, das in Richtung Kabelschuh mit einem Kabelendverschluss 6 versehen ist, um eine Feldsteuerung durchzuführen und Kriechströme entlang der Oberfläche zu vermeiden. Auch das Mittelspannungskabel 5 endet am unteren Ende der Fig. 1 nicht, sondern setzt sich weiter fort. Am Ende des M12-Gewindebolzens 3 ist der Koppler 1 aufgeschraubt, von dem ein sechseckförmiger Ansatz 7 eines Adapters zu erkennen ist. Über diesen Ansatz 7 kann der Koppler 1 beispielsweise mit einem Maulschlüssel gehalten werden, wenn der M12-Gewindebolzen 3 gedreht wird.

An dem Koppler 1 ist ferner eine nach unten gerichtete Kabeltülle 8 zu erkennen, über die ein nicht eingezeichnetes Kommunikation- und/oder Messkabel aus dem Koppler 1 geführt werden kann. Wenn der Koppler 1 lediglich für Kommunikationsaufgaben, beispielsweise zur Übertragung von Breitband-Powerline-Signalen, genutzt wird, wäre lediglich ein Kommunikationskabel über die Kabeltülle in den Koppler 1 geführt. Wenn der Koppler 1 lediglich zu Messzwecken ausgebildet ist, wäre ein Messkabel über die Kabeltülle 8 in den Koppler 1 führen, um Messsignale aus dem Koppler zu einem Messmittel zu übertragen. Wenn der Koppler 1 sowohl für Mess- als auch für Kommunikationsaufgaben ausgestaltet ist, würde ein Mess- und ein Kommunikationskabel über die Kabeltülle 8 nach außen geführt, wobei Mess- und Kommunikationskabel auch kombiniert sein könnten.

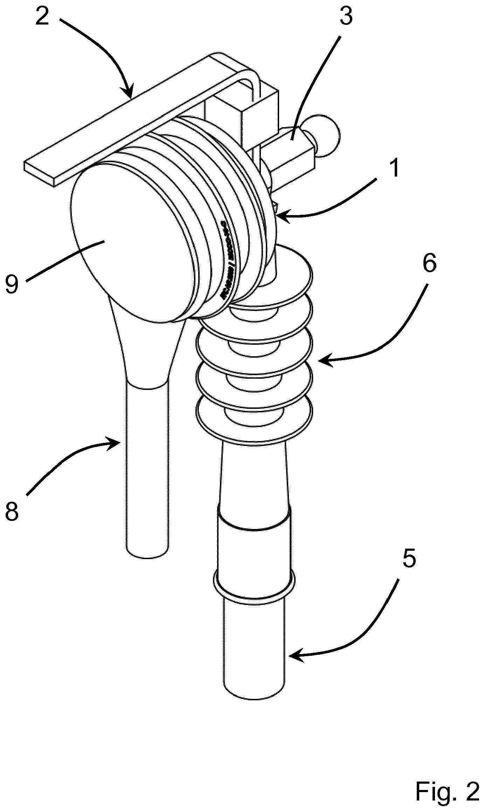

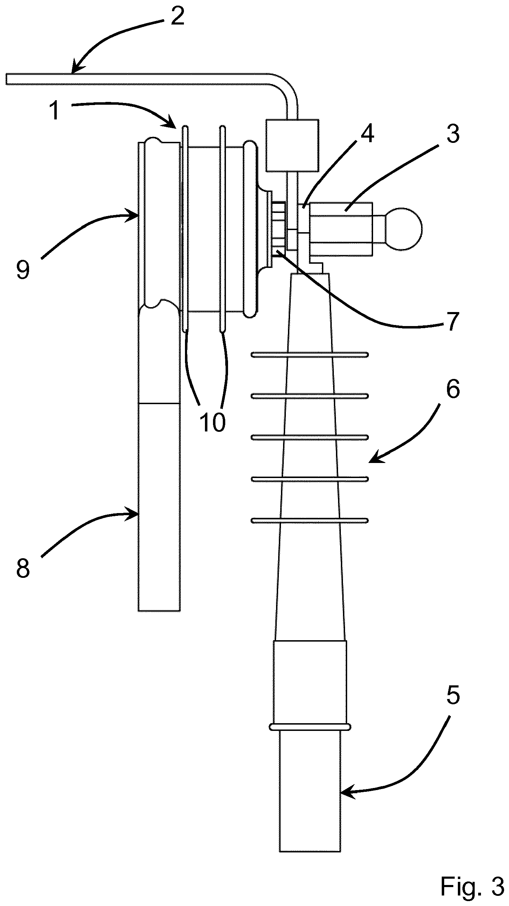

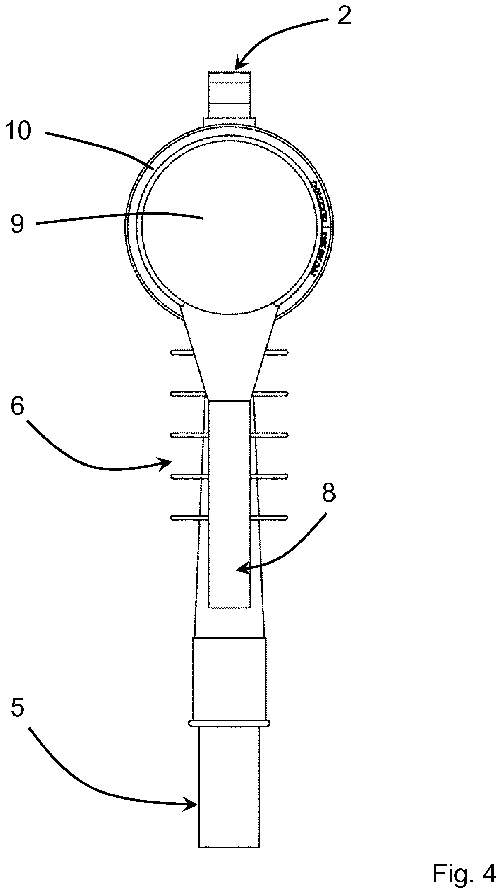

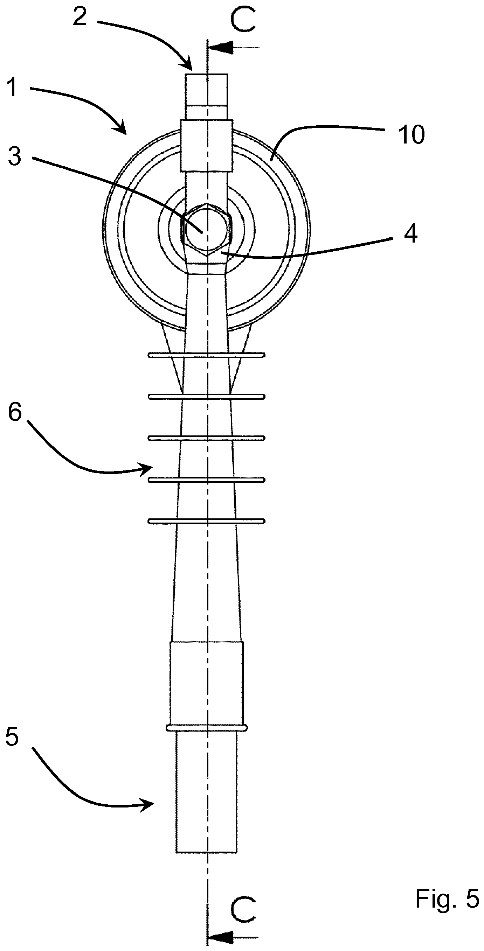

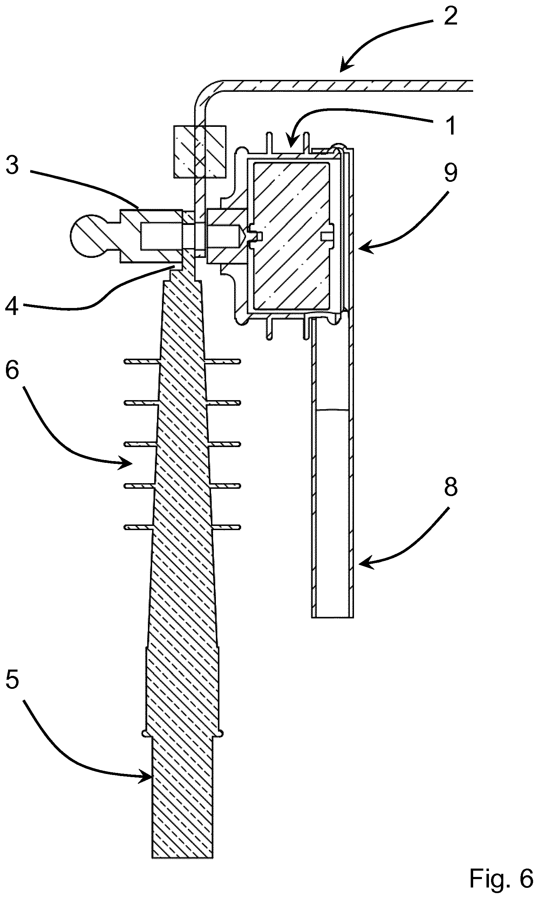

In Fig. 2 ist eine andere Schrägansicht der Anordnung nach Fig. 1 dargestellt. An Koppler 1 ist in dieser Ansicht eine Abdeckung 9 zu erkennen, an deren unteren Ende die Kabeltülle 8 ausgebildet ist. Abdeckung 9 und Kabeltülle können dabei einstückig ausgebildet sein. Die einzelnen Elemente der Anordnung sind in Fig. 3 nochmals in einer Seitenansicht dargestellt. In dieser Ansicht ist deutlich zu erkennen, dass an dem Gehäuse des Kopplers zwei Isolierrippen 10 ausgebildet sind, die um das Gehäuse des Kopplers in Umfangsrichtung des zylindrischen Gehäuses umlaufen. Die umlaufende Ausgestaltung der Isolierrippe 10 ist in Fig. 4 nochmals deutlicher zu sehen. Fig. 5 zeigt schließlich eine Rückansicht des erfindungsgemäßen Kopplers gemäß den vorangehenden Figuren. Ferner ist die Schnittlinie C - C dargestellt. Fig. 6 zeigt einen Schnitt durch die Anordnung entlang der Linie C - C. In Fig. 6 ist auch die innere Struktur der Anordnung genauer zu erkennen. So ist beispielsweise ersichtlich, dass der M12-Gewindebolzen den Kabelschuh 4, die Sammelschiene 2 sowie den Koppler 1 miteinander verbindet.

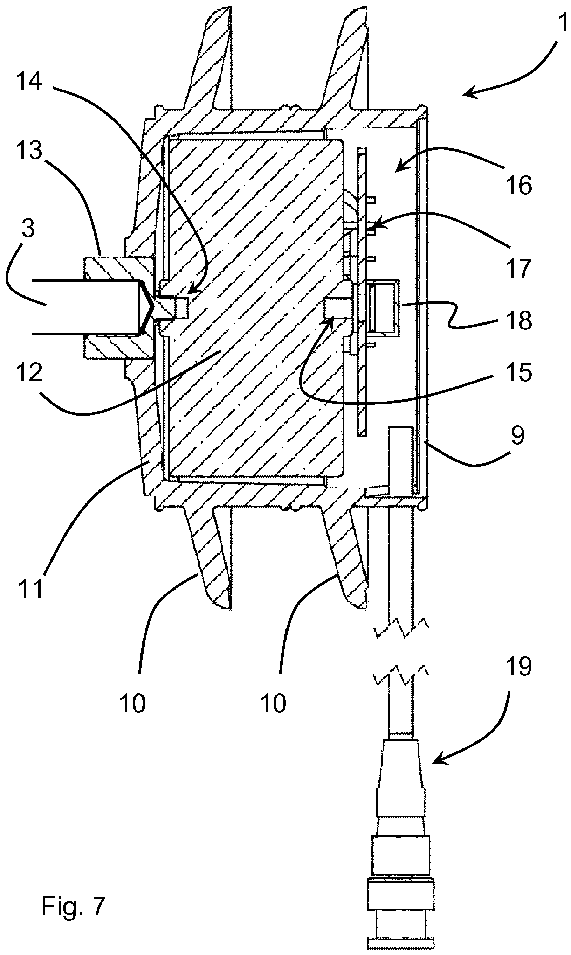

In Fig. 7 ist eine Vergrößerung des Kopplers zu erkennen, wobei eine entsprechende Schnittlinie wie in Fig. 6 verwendet ist und noch weitere Details aufgenommen sind. Koppler 1 umfasst ein Gehäuse 11, in dem eine Koppelkapazität 12 angeordnet ist. An dem Gehäuse 11 sind umlaufende Isolierrippen 10 ausgebildet, die die Strecke von Kriechströmen vergrößern. Gewindebolzen 3 ist in einen Adapter 13 eingeschraubt, der wiederum an der dem Gewindebolzen 3 abgewandten Seite einen Gewindebolzen aufweist, der in ein Befestigungsmittel 14 an einer ersten Elektrode (der Übersichtlichkeit wegen nicht explizit dargestellt) einer Koppelkapazität 12 eingeschraubt ist. Adapter 13 ist in Längsrichtung teilweise von der Wandung des Gehäuses 11 umgeben, sodass Kräfte, die auf den Adapter wirken, auf das Gehäuse 11 abgeleitet wird. Der Kontaktbereich ist dabei etwas verstärkt, um mehr Stütze zu bieten. Der Bereich zwischen Gehäusewandung 11 und Koppelkapazität 12 ist mit einem Vergussmittel ausgefüllt.

An der der ersten Elektrode abgewandten Seite der Koppelkapazität 12 ist ein Befestigungsmittel 15 an einer zweiten Elektrode (der Übersichtlichkeit wegen nicht explizit dargestellt) der Koppelkapazität 12 ausgebildet. Bei der zweiten Elektrode ist in dem Gehäuse 11 ein Anschlussraum 16 ausgebildet, in dem ein auf einer Platine aufgebautes Koppelnetzwerk 17 angeordnet ist. Das Koppelnetzwerk 17 ist mit einer M6-Schraube 18 in dem Befestigungsmittel 15 verschraubt, das - ebenso wie das Befestigungsmittel an der ersten Elektrode - als M6-Gewindebuchse realisiert. Der Anschlussraum 16 ist durch eine Abdeckung 9 abgeschlossen, die in diesem Fall über keine Kabeltülle verfügt. Ein Kommunikationskabel 19 ist vielmehr durch eine Ausbrechung an dem Rand des Gehäuses 11 geführt und ist an der dem Koppelnetzwerk abgewandten Seite mit einem Kommunikationsmittel, beispielsweise einem Breitband-Powerline-Modem (BPL-Modem), verbunden. Die Koppelkapazität 12 weist eine erste Elektrode, eine zweite Elektrode und ein zwischen der ersten Elektrode und der zweiten Elektrode angeordnetes Dielektrikum auf. Der Kondensator ist im Wesentlichen als Plattenkondensator ausgebildet.

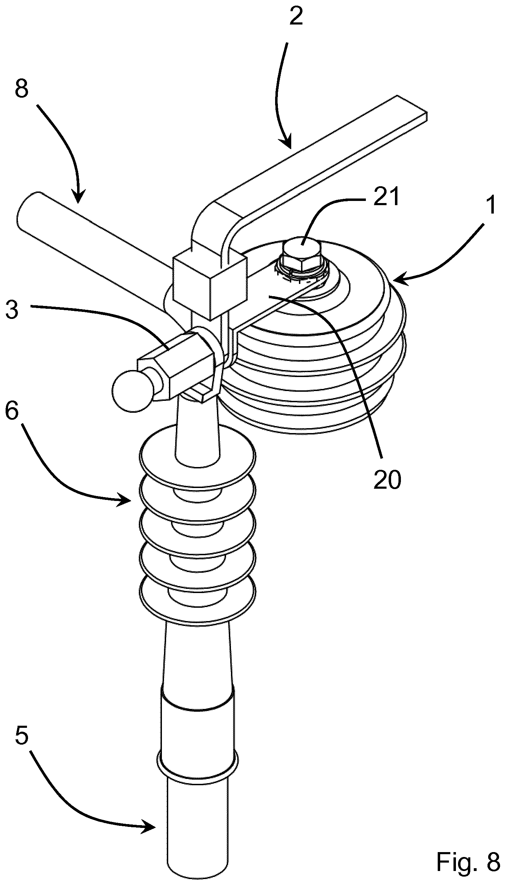

Fig. 8 zeigt eine Schrägansicht eines zweiten Ausführungsbeispiels eines erfindungsgemäßen Kopplers in einer anderen Installationssituation. Der Koppler 1 ist wiederum über einen Gewindebolzen 3 an einer Sammelschiene 2 - dem Betriebsmittel des Mittelspannungsnetzwerks - befestigt, wobei in dieser Installationssituation ein Befestigungswinkel 20 für die Befestigung des Kopplers eingesetzt ist. Der Befestigungswinkel 20 ist über eine nicht dargestellte Mutter mit dem Gewindebolzen 3 verbunden, die zusätzlich für eine Befestigung eines Kabelschuhs 4 eines Mittelspannungskabels 5 mit einem Kabelendverschluss 6 an der Sammelschiene 2 sorgt. Der Koppler 1 selbst ist an der Seite des Befestigungswinkels 20, die von dem Gewindebolzen 3 abgewandt ist, mit einer M12-Schraube 21 befestigt. Diese Installationssituation nimmt zwar in Längsrichtung des Gewindebolzens etwas mehr Platz in Anspruch. Allerdings hat diese Ausgestaltung den Vorteil, dass die Scherkräfte auf das Befestigungsmittel an der ersten Elektrode der Koppelkapazität im Vergleich zu einer direkten Befestigung des Kopplers ohne Befestigungswinkel reduziert sind. Dies ist insbesondere dann von Vorteil, wenn mehrere Kopplermodule zu einem Kopplersystem verbunden werden.

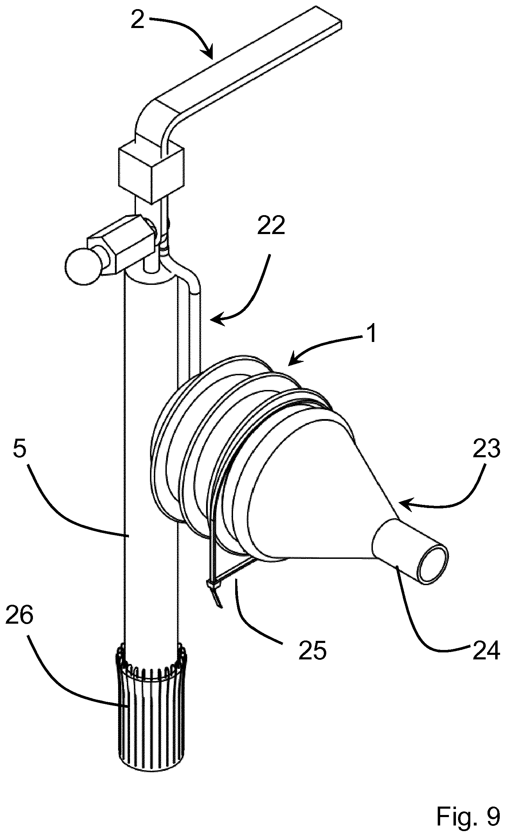

In Fig. 9 ist ein weiteres Ausführungsbeispiel eines erfindungsgemäßen Kopplers dargestellt. Der Koppler 1 ist dabei über einen Befestigungsarm 22 mit einem Gewindebolzen 3 verbunden, der wiederum eine Verbindung zu einer Sammelschiene 2 herstellt. Der Befestigungsarm 22 ist durch ein relativ kurzes Stück eines Hochspannungskabels gebildet. Mit dem Gewindebolzen 3 ebenso verbunden ist ein Mittelspannungskabel, das nach unten wegführt und an dieser Stelle ohne Kabelendverschluss ausgeführt ist. Am unteren Ende des Mittelspannungskabels 5 ist ein Schirmgeflecht 26 angedeutet. In dieser Ausgestaltung ist eine trichterförmige Abdeckung 23 vorgesehen, an deren Ende sich eine Kabeltülle 24 befindet, durch die das Mess- und/oder Kommunikationskabel nach außen geführt wird. Zur Sicherung der trichterförmigen Abdeckung 23 vor einem Abrutschen vom Gehäuse des Kopplers 1 ist ein Kabelbinder 24 vorgesehen, der in der Darstellung nach Fig. 9 noch nicht angezogen ist. Zur Sicherung der trichterförmigen Abdeckung würde der Kabelbinder 25 geschlossen werden.

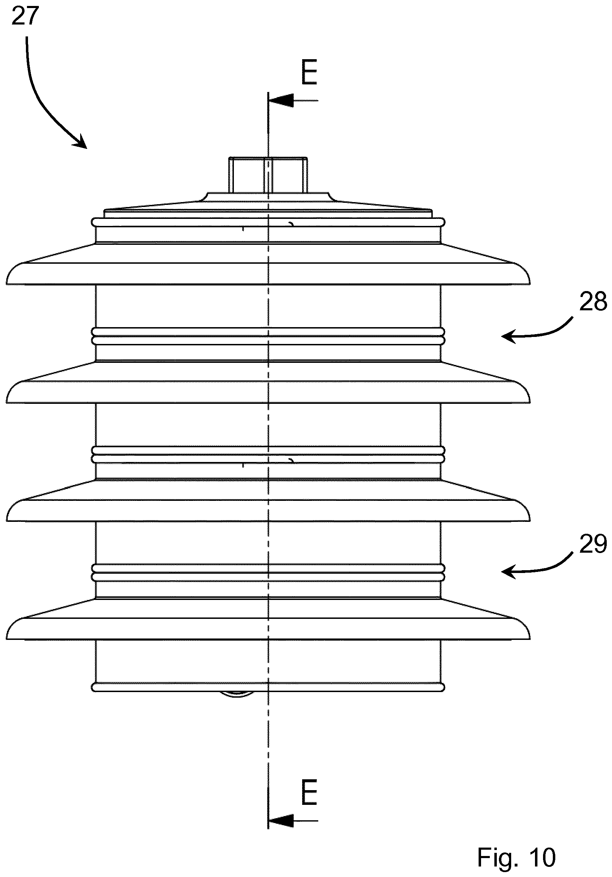

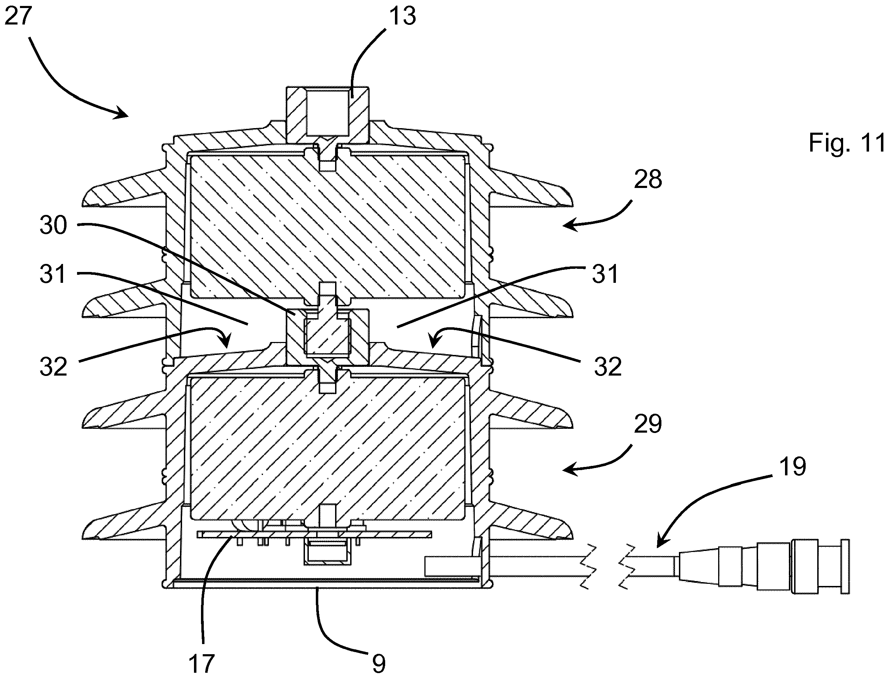

In den Fig. 10 und 11 ist ein erfindungsgemäßes Kopplersystem 27 dargestellt, wobei Fig. 10 eine Seitenansicht des Kopplersystems und Fig. 11 einen Querschnitt durch das Kopplersystem entlang der Linie E - E zeigt. Das Kopplersystem 27 ist durch zwei Kopplermodule 28 und 29 aufgebaut. Das untere Kopplermodul 29 entspricht dabei den bereits im Zusammenhang mit Fig. 7 diskutierten Koppler 1. Jedes Kopplermodul kann nämlich durch Anschließen eines Koppelnetzwerks zu einem Koppler ergänzt werden, wie er in den Fig. 1 bis 9 Verwendung findet.

An dem Befestigungsmittel an der ersten Elektrode des Kopplermoduls 29 ist ein Adapterstück 30 angeordnet, über das die erste Elektrode des Kopplermoduls 29 mit der zweiten Elektrode des oberen Kopplermoduls 28 verbunden ist. In das Befestigungsmittel an der ersten Elektrode des Kopplermoduls 28 ist ein Adapter 13 eingeschraubt, der wiederum einen Anschluss und ein Befestigen des Kopplersystems an einem Betriebsmittel des Energieversorgungsnetzwerks erlaubt. Es ist zu erkennen, dass das Gehäuse des Kopplermoduls 29 bei der ersten Elektrode derart auf das Gehäuse des Kopplermoduls 28 bei der zweiten Elektrode abgestimmt ist, dass das Kopplermodul 28 formschlüssig in das Kopplermodul 29 eingreift. Es kommt eine Art Nut-Feder-Anordnung zum Einsatz. Ein zwischen den Kopplermodulen 28 und 29 gebildete Zwischenraum 31 ist mit einer Vergussmasse ausgefüllt. Als Vergussmittel kann ein niederviskoses Silikon verwendet werden. Zum Vergießen könnte das Kopplermodul 28 umgedreht, sodass der Zwischenraum 31 nach oben zeigt. Anschließend würde das Adapterstück 30 in das Befestigungsmittel an der zweiten Elektrode des Kopplermoduls 28 eingeschraubt. Nach diesen vorbereiteten Schritten würde der Zwischenraum 31 mit einer Vergussmasse ausgefüllt. Anschließend würde das Kopplermodul 29 in das Adapterstück 30 eingeschraubt. Durch die Abschrägung 32 an der Gehäuseseite bei der ersten Elektrode des Kopplermoduls 29 wird das überschüssige Vergussmaterial von dem Adapterstück 30 weg- und - sofern erforderlich - aus dem Gehäuse gedrückt. Sollten Luftblasen in dem Vergussmaterial vorhanden sein, so werden sie durch die Abschrägung 32 von dem Adapterstück 30 weggedrückt und gegebenenfalls zwischen den Gehäusen der Kopplermodule 28 und 29 nach außen geschoben. Luftblasen werden damit von dem heißen Leiter, der durch Adapterstück 30 gebildet ist, wegtransportiert. Durch die Federnutausgestaltung der Gehäuse ist ein formschlüssiger Kontakt zwischen den Gehäusen gegeben. Nach Austrocknen der Vergussmasse und Anbringen des Koppelnetzwerks 17 sowie der Abdeckung 9 ist das Kopplersystem 27 installationsfähig.

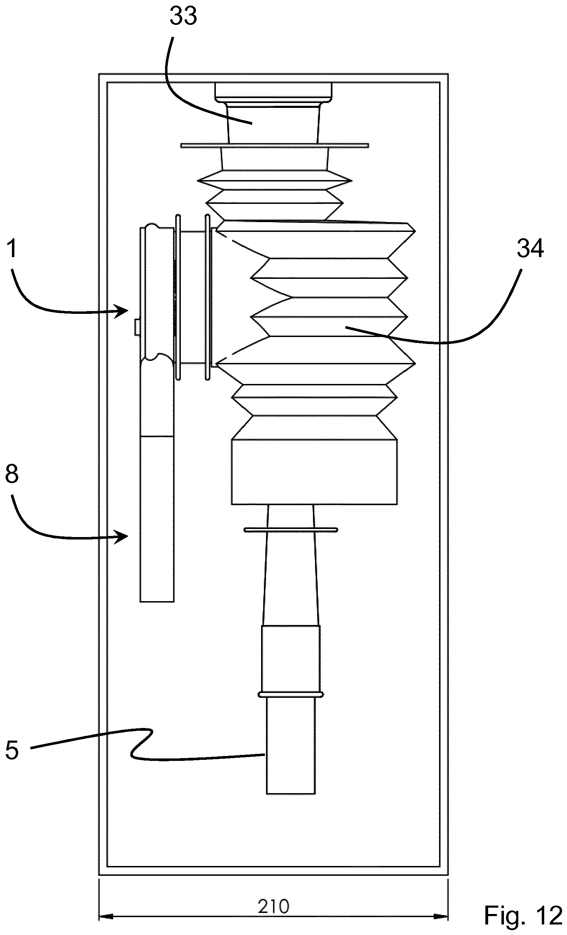

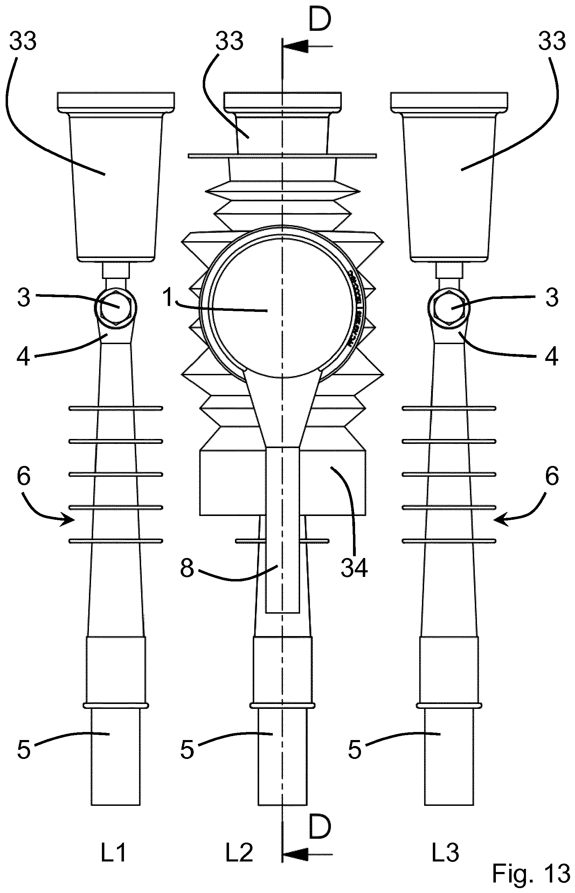

In den Fig. 12 bis 17 ist eine weitere Installationssituation eines erfindungsgemäßen Kopplers dargestellt. Diese Situation kann sich in Kabelanschlussräumen von Kompaktschaltanlagen ergeben, wie beispielsweise bei der bereits in der Einleitung genannten Minex C der Firma Fritz Driescher KG. Fig. 12 zeigt eine Seitenansicht, wie sie bei Blick in eine geöffnete Kompaktschaltanlage des genannten Typs zu erkennen ist. Für die Installation der Anschlussleitungen sowie des Kopplers steht eine Feldbreite von lediglich 210 mm zur Verfügung. Bei anderen Kompaktschaltanlagen ergeben sich ähnlich beengte Verhältnisse. Fig. 13 zeigt eine Ansicht, die ein Blick von links auf die Anlage nach Fig. 12 ergibt. In Fig. 13 sind drei Phasen L1, L2, L3 zu erkennen, wobei die Anordnung für jede der Phasen prinzipiell identisch aufgebaut ist. Im oberen Bereich ist ein Anschlusskonus 33 dargestellt, an dessen unteren Ende ein M12-Gewindebolzen 3 befestigt ist. Mit dem M12-Gewindebolzen ist ein Kabelschuh 4 eine Mittelspannungskabels 5 mit Kabelendverschluss 6 angeschlossen. Oberhalb der Anschlusskonusse ist ein nicht dargestellter Schaltraum angeordnet, in dem die eigentlichen Schaltvorgänge unter Schutzgas-Atmosphäre (beispielsweise Schwefelhexafluorid (SF6)) vorgenommen werden. Die Mittelspannungskabel 5 stellen damit den dreiphasigen Eingang in die Schaltanlage oder einen geschalteten dreiphasigen Ausgang der Schaltanlage dar.

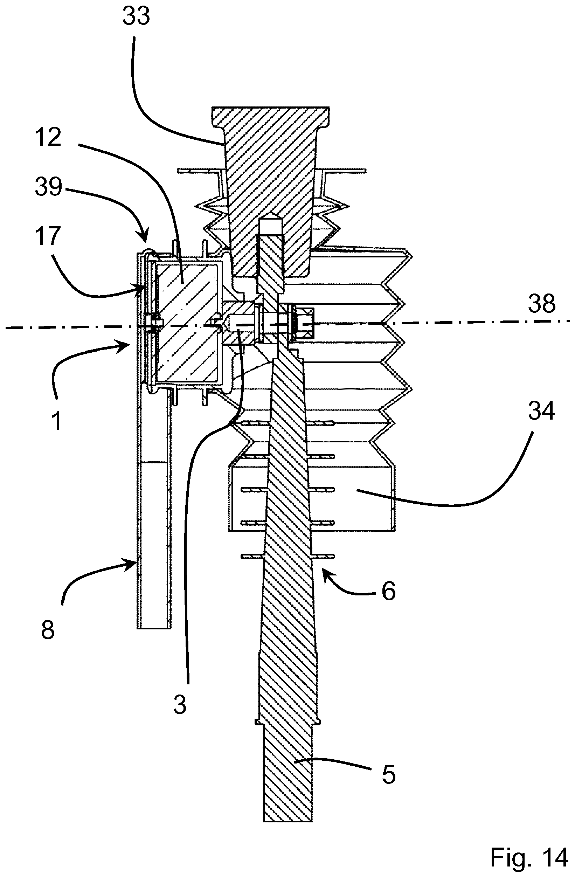

An der in Fig. 13 mittleren Phase L2 ist ein Koppler 1 mit Kabeltülle 8 befestigt. Zum zusätzlichen Schutz ist ein Isolationskörper 34 angebracht. Auf diese Weise kann beispielsweise auf Kundenwünsche hinsichtlich einem zusätzlichen Schutz reagiert werden. In Fig. 14 ist die Anordnung an Leiter L2 nochmals im Schnitt zu erkennen, wobei die zugehörende Schnittlinie D - D in Fig. 13 eingezeichnet ist. Dabei ist auch die Anschlussachse 38 eingezeichnet. Ferner sei noch auf die Anti-Rutsch-Lippe 39 verwiesen, die ein Abrutschen beispielsweise einer Abdeckung 9 in Richtung der Anschlussachse erschwert.

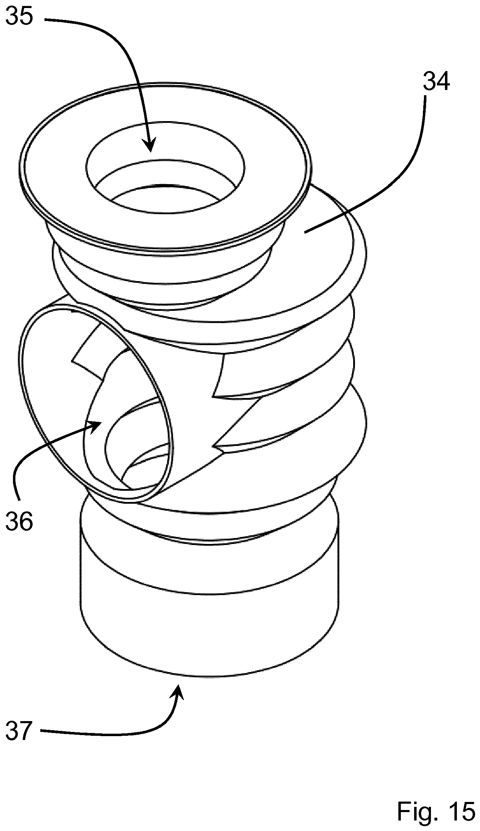

Die Figuren 15 bis 17 zeigen nochmals verschiedene Ansichten des Isolationskörpers 34, wie er in den Fig. 12 bis 14 verwendet ist. Fig. 15 zeigt eine Schrägansicht. Der Isolationskörper 34 weist eine Öffnung 35 für den Anschlusskonus, eine Öffnung 36 für den Koppler und eine Öffnung 37 für das Mittelspannungskabel auf. In Inneren ist der Isolationskörper 34 hohl. Der Isolationskörper ist aus Silikon oder Silikonpolymer hergestellt. Der Isolierkörper kann von oben über den Anschlusskonus geschoben werden, wodurch die Öffnung 35 für den Anschlusskonus den Anschlusskonus nach der Montage formschlüssig aufnimmt.

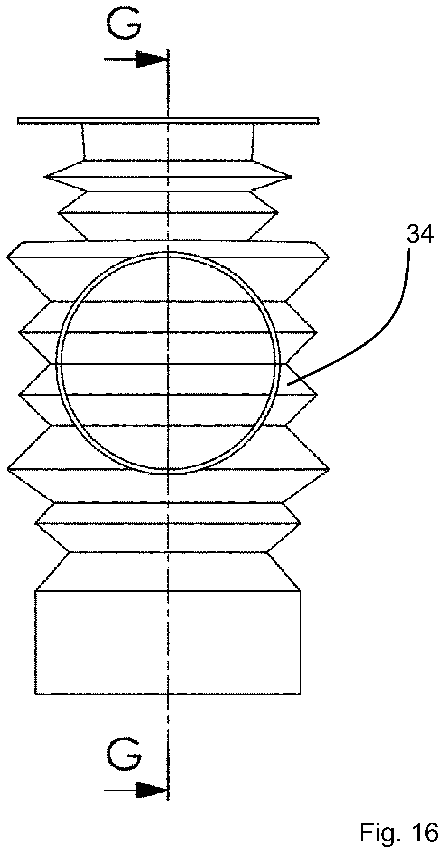

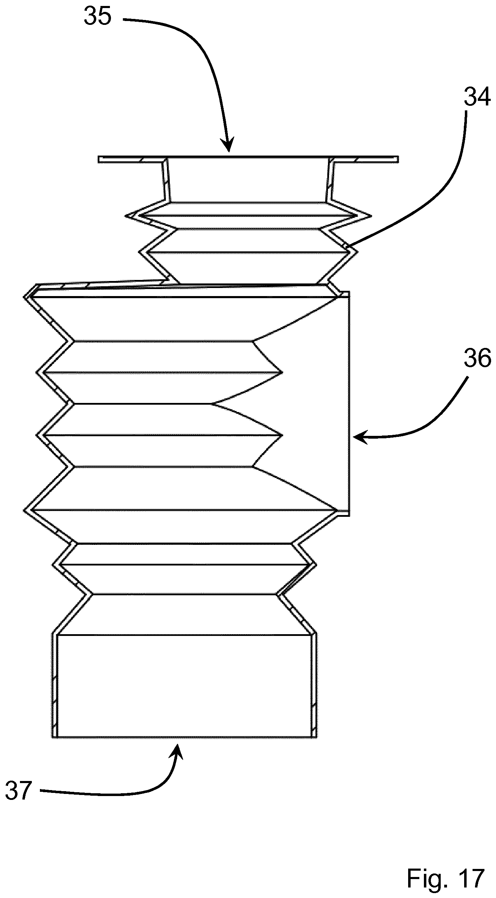

Fig. 16 zeigt eine Frontansicht mit Blick auf die Öffnung 36 für den Koppler. In Fig. 17 ist ein Schnitt durch den Isolationskörper 34 entlang der Linie G - G dargestellt.

### Bezugszeichenliste

- 1: Koppler
- 2: Sammelschiene
- 3: M12-Gewindebolzen
- 4: Kabelschuh
- 5: Mittelspannungskabel
- 6: Kabelendverschluss
- 7: Hexagonaler Gewindekopf
- 8: Kabeltülle
- 9: Abdeckung
- 10: Isolierrippe
- 11: Gehäuse
- 12: Koppelkapazität
- 13: Adapter
- 14: Befestigungsmittel (erste Elektrode)
- 15: Befestigungsmittel (zweite Elektrode)
- 16: Anschlussraum
- 17: Koppelnetzwerk
- 18: M6-Schraube
- 19: Kommunikationskabel
- 20: Befestigungswinkel
- 21: M12-Schraube
- 22: Befestigungsarm
- 23: trichterförmige Abdeckung
- 24: Kabeltülle
- 25: Kabelbinder
- 26: Schirmgeflecht
- 27: Kopplersystem
- 28: Kopplermodul (oberes)
- 29: Kopplermodul (unteres)
- 30: Adapterstück
- 31: Zwischenraum
- 32: Abschrägung
- 33: Anschlusskonus
- 34: Isolationskörper
- 35: Öffnung für Anschlusskonus
- 36: Öffnung für Koppler
- 37: Öffnung für Mittelspannungskabel
- 38: Anschlussachse
- 39: Anti-Rutsch-Lippe

## Patentansprüche

1. Koppler zum Anschluss von Mess- und/oder Kommunikationsmitteln an ein Energieversorgungsnetzwerk, insbesondere ein Mittelspannungsnetzwerk, mit
einem Gehäuse (11),
einer innerhalb des Gehäuses (11) angeordneten ersten Elektrode,
einer innerhalb des Gehäuses (11) angeordneten zweiten Elektrode,
einem zwischen der ersten und der zweiten Elektrode und innerhalb des Gehäuses (11) angeordneten Dielektrikum, wobei die erste Elektrode, die zweite Elektrode und das Dielektrikum eine Koppelkapazität (12) bilden, und
einem Koppelnetzwerk (17), das mit der zweiten Elektrode verbunden ist und zum Anschließen von Mess- und/oder Kommunikationsmitteln ausgebildet ist,
**dadurch gekennzeichnet, dass** an der dem Dielektrikum abgewandten Seite der ersten Elektrode und an der dem Dielektrikum abgewandten Seite der zweiten Elektrode jeweils ein Befestigungsmittel (14, 15) ausgebildet ist, wobei das Befestigungsmittel (14) an der ersten Elektrode zum Anschluss und Befestigen des Kopplers (1) an ein netzspannungführendes Betriebsmittel des Energieversorgungsnetzwerks ausgebildet ist und wobei das Befestigungsmittel (15) an der zweiten Elektrode zum Anschluss des Koppelnetzwerks (17) ausgebildet ist, und
dass das Gehäuse (11) flach ausgebildet ist, wobei das Gehäuse (11) in einer Richtung senkrecht zu einer Verbindungslinie zwischen dem Befestigungsmitteln (14, 15) an der ersten und der zweiten Elektrode eine größere Abmessung aufweist als in einer Richtung parallel zu der Verbindungslinie zwischen den Befestigungsmitteln (14, 15) an der ersten und der zweiten Elektrode.

2. Koppler nach Anspruch 1, **dadurch gekennzeichnet, dass** das Befestigungsmittel (14, 15) durch eine Gewindebuchse gebildet ist, in die eine Schraube (18, 21) oder ein Gewindebolzen (3) einschraubbar sind.

3. Koppler nach Anspruch 1 oder 2, **dadurch gekennzeichnet, dass** das Dielektrikum durch eine Keramik gebildet ist, wobei die erste Elektrode und die zweite Elektrode vorzugsweise symmetrisch zueinander und zu der Keramik aufgebaut sind.

4. Koppler nach einem der Ansprüche 1 bis 3, **dadurch gekennzeichnet, dass** an dem Befestigungsmittel (14) an der ersten Elektrode ein Adapter (13) vorzugsweise lösbar befestigt ist, über den die erste Elektrode mit dem Betriebsmittel verbindbar ist, wobei der Adapter (13) vorzugsweise derart ausgebildet ist und vorzugsweise derart mit dem Gehäuse (11) zusammenwirkt, dass Kräfte, die durch das Befestigen des Kopplers (1) an dem Betriebsmittel und/oder während des Haltens des Kopplers (1) durch das Betriebsmittel entstehen, durch den Adapter (13) an das Gehäuse (1) abgeleitet werden.

5. Koppler nach einem der Ansprüche 1 bis 4, **dadurch gekennzeichnet, dass** an oder in dem Gehäuse (11) bei der zweiten Elektrode an der dem Dielektrikum abgewandten Seite ein Anschlussraum (16) ausgebildet ist, in dem das Koppelnetzwerk (17) oder ein Teil des Koppelnetzwerks angeordnet ist, wobei der Koppler (1) vorzugsweise eine Abdeckung (9) umfasst, mittels der der Anschlussraum (16) verschließbar ist, und wobei an der Abdeckung (9) vorzugsweise eine Kabeltülle (8, 24) ausgebildet ist, durch die ein Kabel zum Anschluss der Mess- und/oder Kommunikationsmittel in den Anschlussraum (16) führbar ist.

6. Koppler nach einem der Ansprüche 1 bis 5, **dadurch gekennzeichnet, dass** an einer Außenseite des Gehäuses (1) mindestens eine Isolierrippe (10) angeordnet ist, wobei die Isolierrippe (10) vorzugsweise in einer Ebene parallel zu der ersten und der zweiten Elektrode angeordnet ist und wobei die Isolierrippe (10) vorzugsweise um das Gehäuse (11) umlaufend ausgebildet ist.

7. Koppler nach einem der Ansprüche 1 bis 6, **dadurch gekennzeichnet, dass** das Gehäuse (11) zylindrisch aufgebaut ist, wobei die erste und die zweite Elektrode jeweils parallel zu der Deckfläche des Zylinders angeordnet sind, wobei das Befestigungsmittel (14) an der ersten Elektrode und das Befestigungsmittel (15) an der zweiten Elektrode vorzugsweise bei der Zylinderachse angeordnet und das Gehäuse (11) und die erste und die zweite Elektrode vorzugsweise im Wesentlichen rotationssymmetrisch zu der Zylinderachse aufgebaut sind.

8. Koppler nach einem der Ansprüche 1 bis 7, **dadurch gekennzeichnet, dass** die Abmessung des Gehäuses (11) in einer Richtung senkrecht zu einer Verbindungslinie zwischen den Befestigungsmitteln (14, 15) an der ersten und der zweiten Elektrode im Vergleich zu der Abmessung des Gehäuses in einer Richtung parallel zu einer Verbindungslinie zwischen den Befestigungsmitteln (14, 15) an der ersten und der zweiten Elektrode ein Verhältnis größer als 1,5 zu 1, verzugsweise ein Verhältnis größer 2 zu 1 annimmt.

9. Koppler nach einem der Ansprüche 1 bis 8, **dadurch gekennzeichnet, dass** das Gehäuse (11) an einer Seite eine umlaufende Abschrägung (32) aufweist, wobei Abschrägung (32) vorzugsweise rotationssymmetrisch zu einer Achse ausgebildet ist, die durch die Befestigungsmittel (14, 15) an der ersten und der zweiten Elektrode definiert ist.

10. Koppler nach einem der Ansprüche 1 bis 9, **dadurch gekennzeichnet, dass** die Mess- und/oder Kommunikationsmittel mittels eines Kabels (19) mit dem Koppelnetzwerk (17) verbunden ist, wobei das Kabel (19) derart ausgebildet ist, dass ein Durchschlag der Koppelkapazität (12) zum Schutz der angeschlossenen Mess- und/oder Kommunikationsmittel zu einer Zerstörung des Kabels (19) führt.

11. Koppler nach einem der Ansprüche 1 bis 10, **gekennzeichnet durch** einen Befestigungswinkel (20) oder einen Befestigungsarm (22), mittels dem das Befestigungsmittel (14) an der ersten Elektrode mit dem Betriebsmittel, vorzugsweise einer Sammelschiene (2) des Energieversorgungsnetzwerks, verbunden ist.

12. Kopplermodul, das durch ein Koppelnetzwerk (17) zu einem Koppler (1) nach einem der Ansprüche 1 bis 11 ergänzbar ist, mit
einem Gehäuse (11),
einer innerhalb des Gehäuses (11) angeordneten ersten Elektrode,
einer innerhalb des Gehäuses (11) angeordneten zweiten Elektrode, und
einem zwischen der ersten und der zweiten Elektrode und innerhalb des Gehäuses angeordneten Dielektrikum, wobei die erste Elektrode, die zweite Elektrode und das Dielektrikum eine Koppelkapazität (12) bilden,
**dadurch gekennzeichnet, dass** an der dem Dielektrikum abgewandten Seite der ersten Elektrode und an der dem Dielektrikum abgewandten Seite der zweiten Elektrode jeweils ein Befestigungsmittel (14, 15) ausgebildet ist, wobei das Befestigungsmittel (14) an der ersten Elektrode zum Anschluss und Befestigen des Kopplermoduls (28, 29) an ein netzspannungführendes Betriebsmittel des Energieversorgungsnetzwerks ausgebildet ist und wobei das Befestigungsmittel (15) an der zweiten Elektrode zum Anschluss des Koppelnetzwerks (17) ausgebildet ist, und
dass das Gehäuse (11) flach ausgebildet ist, wobei das Gehäuse (11) in einer Richtung senkrecht zu einer Verbindungslinie zwischen dem Befestigungsmitteln (14, 15) an der ersten und der zweiten Elektrode eine größere Abmessung aufweist als in einer Richtung parallel zu der Verbindungslinie zwischen den Befestigungsmitteln (14, 15) an der ersten und der zweiten Elektrode.

13. Kopplermodul nach Anspruch 12, **dadurch gekennzeichnet, dass** eine Seite des Gehäuses (11) bei der ersten Elektrode derart auf eine Seite des Gehäuses (11) bei der zweiten Elektrode abgestimmt ist, dass das Kopplermodul (28) in ein zweites gleichartiges Kopplermodul (29) zumindest teilweise formschlüssig eingreift und dass das Befestigungsmittel (14) an der ersten Elektrode des Kopplermoduls (29), gegebenenfalls über ein Adapterstück (30), mit dem Befestigungsmittel (15) an der zweiten Elektrode des zweiten Kopplermoduls (28) verbindbar ist.

14. Kopplersystem zum Anschluss von Mess- und/oder Kommunikationsmitteln an ein Energieversorgungsnetzwerk, insbesondere ein Mittelspannungsnetzwerk, umfassend
mindestens zwei Kopplermodule (28, 29) nach Anspruch 12 oder 13, wobei die Kopplermodule (28, 29) im Wesentlichen gleich aufgebaut sind, und
ein Koppelnetzwerk (17), mit dem die Mess- und/oder Kommunikationsmittel verbindbar sind,
wobei an dem Befestigungsmittel an der zweiten Elektrode eines der Kopplermodule (29) das Koppelnetzwerk (17) angeschlossen ist, wobei zum Bilden eines Stapels aus Kopplermodulen das weitere Kopplermodul (28)/jedes der weiteren Kopplermodule jeweils mit dem Befestigungsmittel (15) der zweiten Elektrode an dem Befestigungsmittel (14) der ersten Elektrode eines anderen Kopplermoduls (28) befestigt ist und
wobei das Befestigungsmittel (14) an der ersten Elektrode des Kopplermoduls (28), das innerhalb des Stapels am weitesten von dem Koppelnetzwerk (17) entfernt ist, mit einem spannungsführenden Betriebsmittel des Energieversorgungsnetzwerks verbindbar ist.

15. Kopplersystem nach Anspruch 14, **dadurch gekennzeichnet, dass** der zwischen zwei benachbarten Kopplermodulen (28, 29) gebildete Raum mit einer Vergussmasse ausgefüllt ist.

## Claims

1. Coupler for connecting measurement and/or communication means to an energy supply network, in particular a medium-voltage network, having
a housing (11),
a first electrode which is arranged inside the housing (11),
a second electrode which is arranged inside the housing (11),
a dielectric which is arranged between the first and the second electrode and inside the housing (11), wherein the first electrode, the second electrode and the dielectric form a coupling capacitor (12), and
a coupling network (17) which is connected to the second electrode and which is constructed to connect measurement and/or communication means,
**characterised in that**, at the side of the first electrode facing away from the dielectric and at the side of the second electrode facing away from the dielectric, a securing means (14, 15) is constructed in each case, wherein the securing means (14) is constructed on the first electrode for connecting and securing the coupler (1) to a network-voltage-carrying operating means of the energy supply network, and
wherein the securing means (15) on the second electrode is constructed for connecting the coupling network (17), and **in that** the housing (11) is constructed in a flat manner, wherein the housing (11) in a direction perpendicular to a connection line between the securing means (14, 15) on the first and the second electrode has a larger dimension than in a direction parallel with the connection line between the securing means (14, 15) on the first and the second electrode.

2. Coupler according to claim 1, **characterised in that** the securing means (14, 15) is formed by means of a threaded bush into which a screw (18, 21) or a threaded bolt (3) can be screwed.

3. Coupler according to claim 1 or 2, **characterised in that** the dielectric is formed by means of a ceramic material, wherein the first electrode and the second electrode are preferably constructed symmetrically with respect to each other and to the ceramic material.

4. Coupler according to any one of claims 1 to 3, **characterised in that** there is preferably releasably secured to the securing means (14) on the first electrode an adapter (13) via which the first electrode can be connected to the operating means, wherein the adapter (13) is preferably constructed in such a manner and preferably cooperates with the housing (11) in such a manner that forces which are produced by securing the coupler (1) to the operating means and/or during the retention of the coupler (1) by the operating means are directed away by the adapter (13) to the housing (11).

5. Coupler according to any one of claims 1 to 4, **characterised in that** there is formed on or in the housing (11) at the second electrode at the side facing away from the dielectric a connection space (16) in which the coupling network (17) or a portion of the coupling network is arranged, wherein the coupler (1) preferably comprises a cover (9) by means of which the connection space (16) can be closed, and wherein there is preferably formed on the cover (9) a cable bushing (8, 24) through which a cable can be guided to connect the measurement and/or communication means in the connection space (16).

6. Coupler according to any one of claims 1 to 5, **characterised in that** there is arranged at an outer side of the housing (1) at least one insulating rib (10), wherein the insulating rib (10) is preferably arranged in a plane parallel with the first and the second electrode and wherein the insulating rib (10) is preferably constructed so as to extend around the housing (11).

7. Coupler according to any one of claims 1 to 6, **characterised in that** the housing (11) is constructed in a cylindrical manner, wherein the first and the second electrode are each arranged parallel with the covering face of the cylinder, wherein the securing means (14) on the first electrode and the securing means (15) on the second electrode are preferably arranged at the cylinder axis and the housing (11) and the first and the second electrode are preferably constructed in a substantially rotationally symmetrical manner with respect to the cylinder axis.

8. Coupler according to any one of claims 1 to 7, **characterised in that** the dimension of the housing (11) in a direction perpendicular to a connection line between the securing means (14, 15) on the first and the second electrode in comparison with the dimension of the housing in a direction parallel with a connection line between the securing means (14, 15) on the first and the second electrode assumes a relationship greater than 1.5 to 1, preferably a relationship greater than 2 to 1.

9. Coupler according to any one of claims 1 to 8, **characterised in that** the housing (11) has a peripheral chamfered portion (32) at one side, wherein the chamfered portion (32) is preferably constructed in a rotationally symmetrical manner with respect to an axis which is defined by the securing means (14, 15) on the first and the second electrode.

10. Coupler according to any one of claims 1 to 9, **characterised in that** the measurement and/or communication means is connected by means of a cable (19) to the coupling network (17), wherein the cable (19) is constructed in such a manner that a breakdown of the coupling capacitor (12) to protect the connected measurement and/or communication means leads to a destruction of the cable (19).

11. Coupler according to any one of claims 1 to 10, **characterised by** a securing angle (20) or a securing arm (22) by means of which the securing means (14) on the first electrode is connected to the operating means, preferably a busbar (2) of the energy supply network.

12. Coupler module which can be supplemented by a coupling network (17) to a coupler (1) according to any one of claims 1 to 11, having
a housing (11),
a first electrode which is arranged inside the housing (11),
a second electrode which is arranged inside the housing (11), and
a dielectric which is arranged between the first and the second electrode and inside the housing, wherein the first electrode, the second electrode and the dielectric form a coupling capacitor (12),
**characterised in that**, at the side of the first electrode facing away from the dielectric and at the side of the second electrode facing away from the dielectric, a securing means (14, 15) is constructed in each case, wherein the securing means (14) is constructed on the first electrode for connecting and securing the coupler module (28, 29) to a network-voltage-carrying operating means of the energy supply network, and wherein the securing means (15) on the second electrode is constructed for connecting the coupling network (17), and
**in that** the housing (11) is constructed in a flat manner, wherein the housing (11) in a direction perpendicular to a connection line between the securing means (14, 15) on the first and the second electrode has a larger dimension than in a direction parallel with the connection line between the securing means (14, 15) on the first and the second electrode.

13. Coupler module according to claim 12, **characterised in that** a side of the housing (11) at the first electrode is adapted to a side of the housing (11) at the second electrode in such a manner that the coupler module (28) at least partially engages in a positive-locking manner in a second identical coupler module (29) and that the securing means (14) on the first electrode of the coupler module (29), where applicable by means of an adapter piece (30), can be connected to the securing means (15) on the second electrode of the second coupler module (28).

14. Coupler system for connecting measurement and/or communication means to an energy supply network, in particular a medium-voltage network, comprising
at least two coupler modules (28, 29) according to claim 12 or 13, wherein the coupler modules (28, 29) are constructed in a substantially identical manner, and
a coupling network (17) to which the measurement and/or communication means can be connected,
wherein the coupling network (17) is connected to the securing means on the second electrode of one of the coupler modules (29), wherein in order to form a stack of coupler modules the additional coupler module (28)/each of the additional coupler modules is/are secured using the securing means (15) of the second electrode to the securing means (14) of the first electrode of another coupler module (28), and
wherein the securing means (14) at the first electrode of the coupler module (28) which is located inside the stack furthest away from the coupling network (17) can be connected to a voltage-carrying operating means of the energy supply network.

15. Coupler system according to claim 14, **characterised in that** the space which is formed between two adjacent coupler modules (28, 29) is filled with a casting compound.

## Revendications

1. Coupleur pour le raccordement de moyens de mesure et/ou de communication à un réseau d'alimentation en énergie, plus particulièrement un réseau moyenne tension, avec
un boîtier (11),
une première électrode disposée à l'intérieur du boîtier (11),
une deuxième électrode disposée à l'intérieur du boîtier (11),
un diélectrique disposé entre la première et la deuxième électrode et à l'intérieur du boîtier (11), la première électrode, la deuxième électrode et le diélectrique constituant une capacité de couplage (12), et
un réseau de couplage (17), relié avec la deuxième électrode et conçu pour le raccordement de moyens de mesure et/ou de communication, **caractérisé en ce que**, sur le côté de la première électrode opposé au diélectrique et sur le côté de la deuxième électrode opposé au diélectrique, se trouve un moyen de fixation (14, 15), le moyen de fixation (14) étant disposé sur la première électrode pour le raccordement et la fixation du coupleur (1) à un équipement conduisant la tension du réseau du réseau d'alimentation en énergie et le moyen de fixation (15) étant disposé sur la deuxième électrode pour le raccordement du réseau de couplage (17) et
le boîtier (11) est plat, le boîtier (11) présentant, dans une direction perpendiculaire à une ligne de liaison entre les moyens de fixation (14, 15) sur la première et la deuxième électrode, une dimension supérieure à la dimension dans une direction parallèle à la ligne de liaison entre les moyens de fixation (14, 15) sur la première et la deuxième électrode.

2. Coupleur selon la revendication 1, **caractérisé en ce que** le moyen de fixation (14, 15) est constitué d'une douille filetée dans laquelle une vis (18, 21) ou une tige filetée (3) peut être vissée.

3. Coupleur selon la revendication 1 ou 2, **caractérisé en ce que** le diélectrique est constitué d'une céramique, la première électrode et la deuxième électrode étant conçues de préférence de manière symétrique entre elles et par rapport à la céramique.

4. Coupleur selon l'une des revendications 1 à 3, **caractérisé en ce que**, sur le moyen de fixation (14) sur la première électrode, est fixé, de préférence de manière amovible, un adaptateur (13), par l'intermédiaire duquel la première électrode peut être reliée avec l'équipement, l'adaptateur (13) étant de préférence conçu et interagissant avec le boîtier (11) de façon à ce que les forces qui apparaissent du fait de la fixation du coupleur (1) à l'équipement et/ou pendant le maintien du coupleur (1) par l'équipement, sont dérivées par l'adaptateur (13) vers le boîtier (1).

5. Coupleur selon l'une des revendications 1 à 4, **caractérisé en ce que**, sur ou dans le boîtier (11), sur la deuxième électrode, sur le côté opposé au diélectrique, un espace de raccordement (16) est réalisé, dans lequel le réseau de couplage (17) ou une partie du réseau de couplage est disposée, le coupleur (1) comprenant de préférence un couvercle (9), au moyen duquel l'espace de raccordement (16) peut être fermé et sur le couvercle (9), de préférence, un passe-câble (8, 24) est prévu, à travers lequel un câble peut être guidé pour le raccordement des moyens de mesure et/ou de communication dans l'espace de raccordement (16).

6. Coupleur selon l'une des revendications 1 à 5, **caractérisé en ce que**, sur un côté extérieur du boîtier (1) se trouve au moins une nervure d'isolation (10), la nervure d'isolation (10) étant de préférence disposée dans un plan parallèle à la première et à la deuxième électrode et la nervure d'isolation (10) étant conçue de préférence de façon à entourer le boîtier (11).

7. Coupleur selon l'une des revendications 1 à 6, **caractérisé en ce que** le boîtier (11) présente une forme cylindrique, la première et la deuxième électrode sont disposées parallèlement à la surface supérieure du cylindre, le moyen de fixation (14) étant disposé sur la première électrode et le moyen de fixation (15) étant disposé sur la deuxième électrode de préférence près de l'axe du cylindre et le boîtier (11) et la première et la deuxième électrode présentent de préférence une symétrie de rotation globale par rapport à l'axe du cylindre.

8. Coupleur selon l'une des revendications 1 à 7, **caractérisé en ce que** le rapport entre la dimension du boîtier (11) dans une direction perpendiculaire à une ligne de liaison entre les moyens de fixation (14, 15) sur la première et la deuxième électrode et la dimension du boîtier dans une direction parallèle à une ligne de liaison entre les moyens de fixation (14, 15) sur la première et la deuxième électrode, est supérieur à 1,5 à 1, de préférence un rapport supérieur à 2 à 1.

9. Coupleur selon l'une des revendications 1 à 8, **caractérisé en ce que** le boîtier (11) comprend, sur un côté, un chanfrein circulaire (32), le chanfrein (32) présentant de préférence une symétrie de rotation par rapport à un axe, qui est défini, par les moyens de fixation (14, 15) sur la première et la deuxième électrode.

10. Coupleur selon l'une des revendications 1 à 9, **caractérisé en ce que** les moyens de mesure et/ou de communication sont reliés à l'aide d'un câble (19) avec le réseau de couplage (17), le câble (19) étant conçu de façon à ce qu'un claquage de la capacité de couplage (12) conduit, pour une protection des moyens de mesure et/ou de communication, à une destruction du câble (19).

11. Coupleur selon l'une des revendications 1 à 10, **caractérisé par** une équerre de fixation (20) ou un bras de fixation (22), à l'aide duquel le moyen de fixation (14) sur la première électrode est relié avec l'équipement, de préférence un rail collecteur (2) du réseau d'alimentation en énergie.

12. Module de couplage pouvant être complété par un réseau de couplage (17), afin d'obtenir un coupleur (1) selon l'une des revendications 1 à 11, avec un boîtier (11),
une première électrode disposée à l'intérieur du boîtier (11),
une deuxième électrode disposée à l'intérieur du boîtier (11),
un diélectrique disposé entre la première et la deuxième électrode et à l'intérieur du boîtier (11), la première électrode, la deuxième électrode et le diélectrique constituant une capacité de couplage (12),
**caractérisé en ce que**, sur le côté de la première électrode opposé au diélectrique et sur le côté de la deuxième électrode opposé au diélectrique, se trouve un moyen de fixation (14, 15), le moyen de fixation (14) étant disposé sur la première électrode pour le raccordement et la fixation du module de couplage (28, 29) à un équipement conduisant la tension du réseau d'alimentation en énergie et le moyen de fixation (15) étant disposé sur la deuxième électrode pour le raccordement du réseau de couplage (17) et
le boîtier (11) est plat, le boîtier (11) présentant, dans une direction perpendiculaire à une ligne de liaison entre les moyens de fixation (14, 15) sur la première et la deuxième électrode, une dimension supérieure à la dimension dans une direction parallèle à la ligne de liaison entre les moyens de fixation (14, 15) sur la première et la deuxième électrode.

13. Module de couplage selon la revendication 12, **caractérisé en ce qu'**un côté du boîtier (11) près de la première électrode est adapté à un côté du boîtier (11) près de la deuxième électrode, de façon à ce que le module de couplage (28) s'emboîte dans un deuxième module de couplage (29) de même type avec une complémentarité de forme au moins partielle et **en ce que** le moyen de fixation (14) peut être relié à la première électrode du module de couplage (29), le cas échéant par l'intermédiaire d'un adaptateur (30), avec le moyen de fixation (15) sur la deuxième électrode du deuxième module de couplage (28).

14. Module de couplage pour le raccordement de moyens de mesure et/ou de communication à un réseau d'alimentation en énergie, plus particulièrement un réseau moyenne tension, comprenant
au moins deux modules de couplage (28, 29) selon la revendication 12 ou 13, les modules de couplage (28, 29) présentant globalement la même structure et
un réseau de couplage (17), avec lequel les moyens de mesure et/ou de communication peuvent être reliés,
le réseau de couplage (17) étant raccordé au moyen de fixation de la deuxième électrode d'un des modules de couplage (29), moyennant quoi, pour la formation d'un empilement de modules de couplage, l'autre module de couplage (28) / chaque des autres modules de couplage est fixé avec le moyen de fixation (15) de la deuxième électrode au moyen de fixation (14) de la première électrode d'un autre module de couplage (28) et
le moyen de fixation (14) de la première électrode du module de couplage (28), qui est le plus éloigné, dans l'empilement, du réseau de couplage (17), peut être relié avec un équipement conducteur de tension du réseau d'alimentation en énergie.

15. Système de couplage selon la revendication 14, **caractérisé en ce que** l'espace formé entre deux modules de couplage (28, 29) adjacents est rempli d'une masse de scellement.
